(19) Europäisches Patentamt
European Patent Office
Office européen des brevets

(11) **EP 2 605 298 A1**

(12) **EUROPEAN PATENT APPLICATION**
published in accordance with Art. 153(4) EPC

(43) Date of publication:
**19.06.2013 Bulletin 2013/25**

(51) Int Cl.:
**H01L 33/54** (2010.01)

(21) Application number: **11816228.8**

(22) Date of filing: **04.08.2011**

(86) International application number:
**PCT/JP2011/004425**

(87) International publication number:
**WO 2012/020559 (16.02.2012 Gazette 2012/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.08.2010 JP 2010178521**

(71) Applicant: **Panasonic Corporation Osaka 571-8501 (JP)**

(72) Inventors:
• **INOUE, Akira**
**2-1-61, Shiromi,**
**Chuo-ku**
**Osaka 540-6207 (JP)**

• **FUJIKANE, Masaki**
**2-1-61, Shiromi,**
**Chuo-ku**
**Osaka 540-6207 (JP)**
• **YOKOGAWA, Toshiya**
**2-1-61, Shiromi,**
**Chuo-ku**
**Osaka 540-6207 (JP)**

(74) Representative: **Grünecker, Kinkeldey, Stockmair & Schwanhäusser**
**Leopoldstrasse 4**
**80802 München (DE)**

(54) **SEMICONDUCTOR LIGHT-EMITTING DEVICE**

(57) Around a nitride-based semiconductor light-emitting element which has a polarization characteristic, a transparent encapsulating member which has a cylindrical shape is provided such that the symmetry plane of the cylindrical shape forms an angle of 25° to 65° with respect to the polarization direction of the nitride-based semiconductor light-emitting element.

FIG.3

**Description**

**TECHNICAL FIELD**

The present invention relates to a semiconductor light-emitting device including a nitride semiconductor light-emitting element which has polarization characteristics.

**BACKGROUND ART**

A nitride semiconductor containing nitrogen (N) as a Group V element is a prime candidate for a material to make a short-wave light-emitting device, because its bandgap is sufficiently wide. Among other things, gallium nitride-based compound semiconductors have been researched and developed particularly extensively. As a result, blue light-emitting diodes (LEDs), green LEDs, and blue semiconductor laser diodes in which the gallium nitride-based compound semiconductors are used have already been used in actual products.

Hereinafter, the gallium nitride-based compound semiconductors are referred to as nitride semiconductors. The nitride semiconductors include a compound semiconductor in which some or all of gallium (Ga) atoms are replaced with at least one of aluminum (Al) and indium (In) atoms. Therefore, the nitride semiconductors are represented by formula $Al_xGa_yIn_zN$ ($0 \leq x$, y, $z \leq 1$, x+y+z=1).

By replacing Ga atoms with Al atoms, the bandgap can be greater than that of GaN. By replacing Ga atoms with In atoms, the bandgap can be smaller than that of GaN. This enables not only emission of short-wave light, such as blue light or green light, but also emission of orange light or red light. Because of such a feature, a nitride semiconductor light-emitting element has been expected to be applied to image display devices and lighting devices.

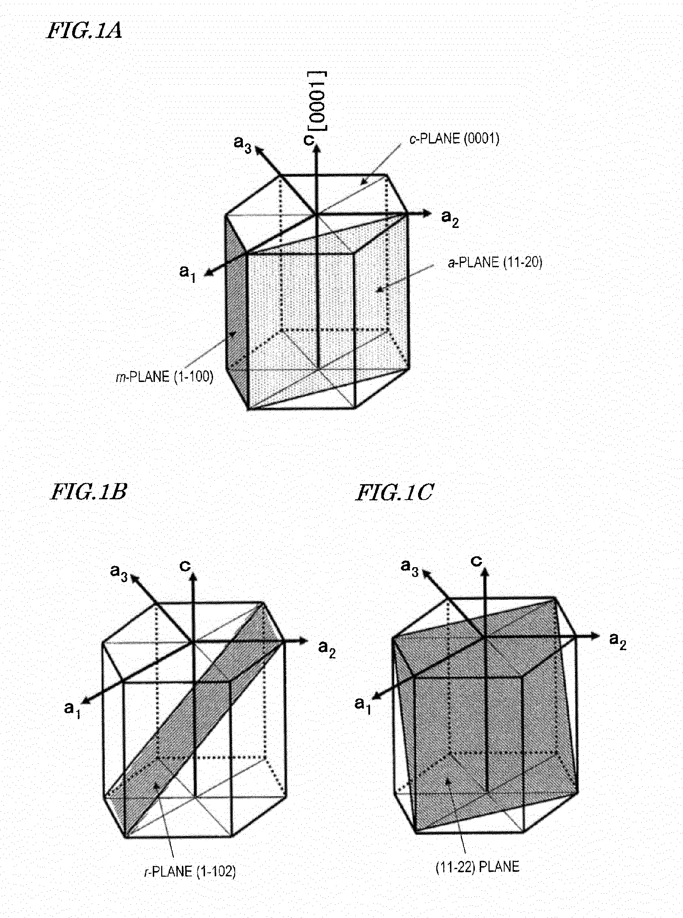

The nitride semiconductor has a wurtzite crystal structure. FIGS. **1A, 1B,** and 1C show planes of a wurtzite crystal structure with four characters (hexagonal indices). In a four-character expression, crystal planes and orientations are expressed using primitive vectors of **a1, a2, a3,** and c. The primitive vector c runs in the [0001] direction, which is called a "c-axis". A plane that intersects with the c-axis at right angles is called either a "c-plane" or a "(0001) plane". FIG. **1A** shows c-plane as well as $a$-plane and $m$-plane. FIG. **1B** shows $r$-plane. FIG. **1C** shows (11-22) plane.

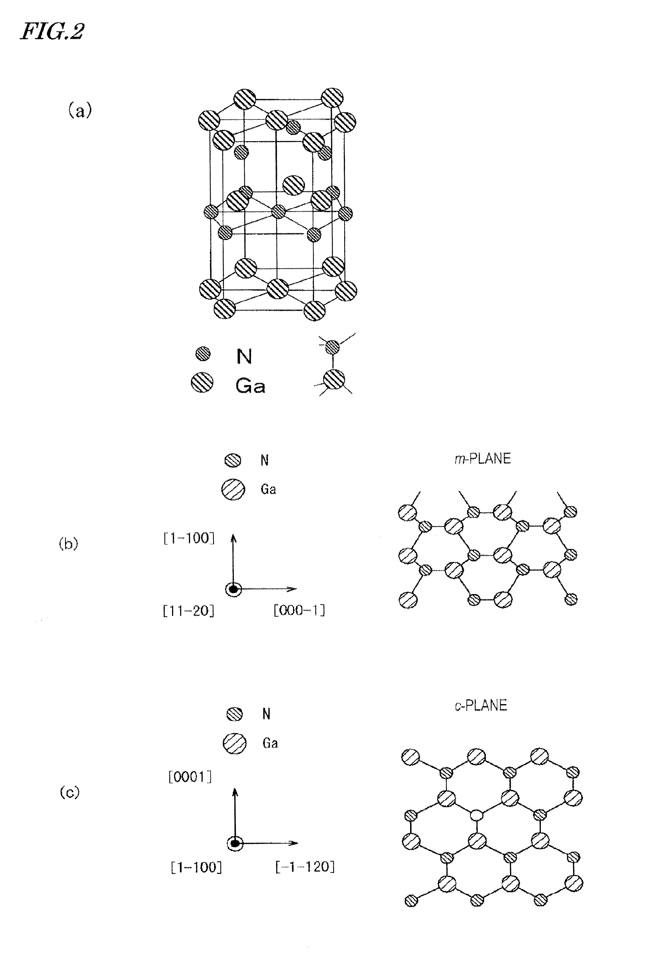

FIG. **2(a)** shows a molecular orbital model of the crystal structure of the nitride semiconductor. FIG. **2(b)** shows an atomic arrangement near an $m$-plane surface, which is observed from the $a$-axis direction. The $m$-plane is perpendicular to the drawing sheet of FIG. **2(b)**. FIG. **2(c)** shows an atomic arrangement at a +c-plane surface, which is observed from the $m$-axis direction. The c-plane is perpendicular to the drawing sheet of FIG. **2(c)**. As seen from FIG. **2(b),** N atoms and Ga atoms reside at a plane which is parallel to the $m$-plane. On the other hand, as seen from FIG. 2(c), the c-plane includes layers in which only Ga atoms reside and layers in which only N atoms reside.

According to the conventional techniques, in fabricating a semiconductor element using nitride semiconductors, a c-plane substrate, i.e., a substrate which has a (0001)-plane principal surface, is used as a substrate on which nitride semiconductor crystals are to be grown. In this case, due to the arrangement of Ga atoms and N atoms, spontaneous electrical polarization is produced in the c-axis direction in the nitride semiconductor. That is why the c-plane is also called a "polar plane". As a result of the electrical polarization, a piezoelectric field is generated along the c-axis direction in the InGaN quantum well in the active layer of the nitride semiconductor light-emitting element. This electric field causes some positional deviation in the distributions of electrons and holes in the active layer, so that the internal quantum yield decreases due to the quantum confinement Stark effect of carriers.

Thus, it has been proposed that a substrate of which the principal surface is a so-called "non-polar plane", such as $m$-plane or $a$-plane, or a so-called "semi-polar plane", such as -r plane or (11-22) plane, be used. As shown in FIG. **1,** the $m$-planes in the wurtzite crystal structure are parallel to the c-axis and are six equivalent planes which intersect with the c-plane at right angles. For example, in FIG. **1A**, the (1-100) plane that is perpendicular to the [1-100] direction is the $m$-plane. The other $m$-planes which are equivalent to the (1-100) plane include (-1010) plane, (10-10) plane, (-1100) plane, (01-10) plane, and (0-110) plane. Here, "-" attached on the left-hand side of a Miller-Bravais index in the parentheses means a "bar".

On the $m$-plane, as shown in FIG. **2(b),** Ga atoms and N atoms are on the same atomic-plane. For that reason, no electrical polarization will be produced perpendicularly to the $m$-plane. Therefore, if a light-emitting element is fabricated using a semiconductor multilayer structure which has been formed on the $m$-plane, no piezoelectric field will be generated in the active layer, thus overcoming the problem that the internal quantum yield (efficiency) is decreased due to the quantum confinement Stark effect of carriers. This also applies to the $a$-plane that is one of the other non-polar planes than the $m$-plane. Also, similar effects can be achieved even in the case of a so-called semi-polar plane, such as -r plane or (11-22) plane.

Further, a nitride semiconductor light-emitting element including an active layer which is formed on the m-plane, $a$-plane, the -r plane, or (11-22) plane has a polarization characteristic which is attributed to the structure of its valence band (see Patent Document 1). For example, a nitride semiconductor active layer formed on the $m$-plane mainly emits light whose electric field intensity is deviated in a direction parallel to the *a*-axis. A light-emitting element which has such a polarization characteristic has been expected to be applied to, for example, a backlight for liquid crystal.

On the other hand, it is theoretically estimated that, when the light-emitting element has a polarization characteristic, it has such a light distribution that the emission intensity is greater in a direction which is perpendicular to the polarization direction. That is, the problem of a nonuniform radiation pattern (light distribution) of the light-emitting element occurs. Thus, Patent Document 2 proposes a light-emitting "diode device which is configured such that the difference in intensity which is attributed to the difference in in-plane azimuth angle of the nitride semiconductor light-emitting element can be reduced. In the fifth embodiment of Patent Document 2, the light emission surface of a package is configured such that the direction of light is changed to a direction of an azimuth angle in which the emission intensity is small in order to reduce the difference in intensity of light emitted from the package which is attributed to the difference in in-plane azimuth angle of the chip placing surface.

In the present specification, light whose electric field intensity is deviated in a specific direction is referred to as "polarized light". For example, light whose electric field intensity is deviated in a direction parallel to X-axis is referred to as "X-axis direction polarized light". The direction parallel to the X-axis on this assumption is referred to as "polarization direction". Note that the "X-axis direction polarized light" not only means linearly-polarized light which is polarized in the X-axis direction but may include linearly-polarized light which is polarized in a different direction. More specifically, the "X-axis direction polarized light" means light in which the intensity (electric field intensity) of light transmitted through a "polarizer which has a polarization transmission axis extending in the X-axis direction" is higher than the electric field intensity of light transmitted through a polarizer which has a polarization transmission axis extending in a different direction. Therefore, the "X-axis direction polarized light" includes not only linearly-polarized light and elliptically-polarized light which are polarized in the X-axis direction but also a wide variety of non-coherent light in which linearly-polarized light and elliptically-polarized light which are polarized in various directions are mixed together.

While rotating the polarization transmission axis of the polarizer around the optical axis, the electric field intensity of light transmitted through the polarizer exhibits the strongest intensity, Imax, and the weakest intensity, Imin. The polarization degree is defined by the following formula:

$$|Imax-Imin|/|Imax+Imin| \qquad \text{Formula (1)}$$

In the case of the "X-axis direction polarized light", when the polarization transmission axis of the polarizer is parallel to the X-axis, the electric field intensity of the light transmitted through the polarizer is Imax. When the polarization transmission axis of the polarizer is parallel to the Y-axis, the electric field intensity of the light transmitted through the polarizer is Imin. In the case of perfectly linearly-polarized light, Imin=0, and therefore, the polarization degree is equal to 1. On other hand, in the case of perfectly unpolarized light, Imax-Imin=0, and therefore, the polarization degree is equal to 0.

A nitride semiconductor light-emitting element which includes an active layer formed on the *m*-plane mainly emits the *a*-axis direction polarized light as described above. Meanwhile, it also emits the c-axis direction polarized light and the *m*-axis direction polarized light. However, the c-axis direction polarized light and the *m*-axis direction polarized light have weaker intensities than the *a*-axis direction polarized light. Thus, in the present specification, the *a*-axis direction polarized light is considered and discussed.

## CITATION LIST

## PATENT LITERATURE

Patent Document 1: Japanese Laid-Open Patent Publication No. 2008-109066
Patent Document 2: Japanese Laid-Open Patent Publication No. 2008-109098

## SUMMARY OF INVENTION

## TECHNICAL PROBLEM

Patent Document 1 intends to maintain the polarization characteristic of a nitride semiconductor light-emitting element. However, when a light-emitting element which has a polarization characteristic is used as a light source, the amount of reflection at an object surface varies depending on the orientation of the polarization, i.e., the installation orientation of the LED, leading to a problem that the appearance of the object varies. This is because the P-polarized light and the S-polarized light exhibit different reflectances (the S-polarization has higher reflectance). Here, the P-polarized light refers to light which has an electric field component that is parallel to the incidence plane. The S-polarized light refers to light which has an electric field component that is perpendicular to the incidence plane. Therefore, in an application which utilizes the polarization characteristic without modification, improving the polarization degree is important. In common lighting applications, there is a problem that the polarization characteristic is a troublesome factor.

Patent Document 2 discloses a configuration which overcomes a problem that the emission intensity is larger in a direction perpendicular to the polarization direction. However, Patent Document 2 intends to improve the light distribution and therefore does not consider the polarization degree of light emitted from a package.

Thus, one of the major objects of the present invention is to provide a nitride semiconductor light-emitting device in which reduction of the polarization degree is realized.

**SOLUTION TO PROBLEM**

A nitride semiconductor light-emitting device of the present invention includes: a nitride semiconductor light-emitting element which is configured to emit from an active layer polarized light which is polarized in a polarization direction which is included in a plane parallel to the active layer; and a transparent encapsulating member covering the nitride semiconductor light-emitting element, the transparent encapsulating member having a symmetry plane which is perpendicular to the active layer, wherein the polarization direction of the nitride semiconductor light-emitting element is inclined by an angle which, does not include 0° or 90° with respect to the symmetry plane of the transparent encapsulating member.

In one embodiment, the polarization direction of the nitride semiconductor light-emitting element is inclined by an angle of not less than 25° and not more than 65° with respect to the symmetry plane of the transparent encapsulating member.

In one embodiment, the polarization direction of the nitride semiconductor light-emitting element is inclined by an angle of not less than 35° and not more than 55° with respect to the symmetry plane of the transparent encapsulating member.

In one embodiment, the transparent encapsulating member has a shape which constitutes part of a semicylinder.

In one embodiment, the transparent encapsulating member has a shape which constitutes part of a circular cone.

In one embodiment, the transparent encapsulating member has a shape which constitutes part of a polygonal prism.

In one embodiment, the transparent encapsulating member has a shape which constitutes part of a polygonal cone.

In one embodiment, the transparent encapsulating member has a shape which constitutes part of an elliptical sphere.

In one embodiment, the Transparent encapsulating member has a shape which constitutes part of a rectangular parallelpiped.

In one embodiment, the nitride semiconductor light-emitting device further includes a mounting base which supports the nitride semiconductor light-emitting element.

Another nitride semiconductor light-emitting device of the present invention includes: a first nitride semiconductor light-emitting element which includes a first active layer, the first nitride semiconductor light-emitting element being configured to emit from the first active layer polarized light which is polarized in a first polarization direction which is included in a plane parallel to the first active layer; a second nitride semiconductor light-emitting element which includes a second active layer, the second nitride semiconductor light-emitting element being configured to emit from the second active layer polarized light which is polarized in a second polarization direction which is included in a plane parallel to the second active layer; and a transparent encapsulating member covering the first nitride semiconductor light-emitting element and the second nitride semiconductor light-emitting element, the transparent encapsulating member having a symmetry plane which is perpendicular to the first and second active layers, wherein each of the first polarization direction of the first nitride semiconductor light-emitting element and the second polarization direction of the second nitride semiconductor light-emitting element is inclined by an angle which does not include 0° or 90° with respect to the symmetry plane of the transparent encapsulating member.

In one embodiment, the first polarization direction and the second polarization direction are parallel 1 to each other.

In one embodiment, the first polarization direction and the second polarization direction are not parallel to each other.

In one embodiment, at least one of the first polarization direction and the second polarization direction is inclined by an angle of not less than 25° and not more than 65° with respect to the symmetry plane of the transparent encapsulating member.

In one embodiment, the polarization direction of the nitride semiconductor light-emitting element is inclined by an angle of not less than 35° and not more than 55° with respect to the symmetry plane of the transparent encapsulating member.

In one embodiment, the transparent encapsulating member has a shape which constitutes part of a semicylinder.

In one embodiment, the transparent encapsulating member has a shape which constitutes part of a circular cone.

In one embodiment, the transparent encapsulating member has a shape which constitutes part of a polygonal prism.

In one embodiment, the transparent encapsulating member has a shape which constitutes part of a polygonal cone.

In one embodiment, the transparent encapsulating member has a shape which constitutes part of an elliptical sphere.

In one embodiment, the transparent encapsulating member has a shape which constitutes part of a rectangular parallelpiped.

In one embodiment, the nitride semiconductor light-emitting device further includes a mounting base which supports the first and second nitride semiconductor light-emitting elements.

Still another nitride semiconductor light-emitting device of the present invention includes: a first nitride semiconductor light-emitting element which includes a first active layer, the first nitride semiconductor light-emitting element being configured to emit from the first active layer polarized light which is polarized in a first polarization direction which is included in a plane parallel to the first active layer; a second nitride semiconductor light-emitting element which includes a second active layer, the second nitride semiconductor light-emitting element being configured to emit from the second active layer polarized light which is polarized in a second polarization direction which is included in a plane parallel to the second active layer; a first transparent encapsulating member covering the first nitride semiconductor light-emitting element, the first transparent encapsulating member having a symmetry plane which is perpendicular to the first active layer; and a second transparent encapsulating member covering the second nitride semiconductor light-emitting element, the second transparent encapsulating member having a symmetry plane which is perpendicular to the second active layer, wherein the first polarization direction of the first nitride semiconductor light-emitting element is inclined by an angle which does not include 0° or 90° with respect to the symmetry plane of the first transparent encapsulating member, and the second polarization direction of the second nitride semiconductor light-emitting element is inclined by an angle which does not include 0° or 90° with respect to the symmetry plane of the second transparent encapsulating member.

In one embodiment, the first polarization direction and the second polarization direction are parallel to each other.

In one embodiment, the first polarization direction and the second polarization direction are not parallel to each other.

In one embodiment, the first polarization direction is inclined by an angle of not less than 25° and not more than 65° with respect to the symmetry plane of the first transparent encapsulating member, and the second polarization direction is inclined by an angle of not less than 25° and not more than 65° with respect to the symmetry plane of the second transparent encapsulating member.

In one embodiment, the first polarization direction is inclined by an angle of not less than 35° and not more than 55° with respect to the symmetry plane of the first transparent encapsulating member, and the second polarization direction is inclined by an angle of not less than 35° and not more than 55° with respect to the symmetry plane of the second transparent encapsulating member.

In one embodiment, at least one of the first transparent encapsulating member and the second transparent encapsulating member has a shape which constitutes part of a semicylinder.

In one embodiment, at least one of the first transparent encapsulating member and the second transparent encapsulating member has a shape which constitutes part of a circular cone.

In one embodiment, at least one of the first transparent encapsulating member and the second transparent encapsulating member has a shape which constitutes part of a polygonal prism.

In one embodiment, at least one of the first transparent encapsulating member and the second transparent encapsulating member has a shape which constitutes part of a polygonal cone.

In one embodiment, at least one of the first transparent encapsulating member and the second transparent encapsulating member has a shape which constitutes part of an elliptical sphere.

In one embodiment, at least one of the first transparent encapsulating member and the second transparent encapsulating member has a shape which constitutes part of a rectangular parallelpiped.

In one embodiment, the nitride semiconductor light-emitting device further includes a mounting base which supports the first and second nitride semiconductor light-emitting elements.

## ADVANTAGEOUS EFFECTS OF INVENTION

According to the present invention, the polarization direction of the nitride semiconductor light-emitting element is inclined by an angle which does not include 0° or 90° with respect to the symmetry plane of the transparent encapsulating member. Therefore, the S-polarization component and the P-polarization component are allowed to be incident on the interface between the outside of the transparent encapsulating member and the transparent encapsulating member. According to this configuration, the polarization direction of transmitted light rotates so that the polarization degree can be reduced, and also, reflection is concerted to elliptical polarization so that the polarization degree can be further reduced.

## BRIEF DESCRIPTION OF DRAWINGS

FIG. **1A** is a diagram showing a wurtzite crystal structure.
FIG. **1B** is a diagram showing a wurtzite crystal structure.
FIG. **1C** is a diagram showing a wurtzite crystal structure.
FIGS. **2(a)** to **2(c)** show the crystal structure of a nitride semiconductor using molecular orbital models.
FIGS. **3(a)** to **3(c)** show a nitride semiconductor light-emitting device of Embodiment 1.
FIGS. **4(a)** and **4(b)** are diagrams illustrating the relationship of incident light, transmitted light, and reflected light at the interface between a transparent encapsulating member of the nitride semiconductor light-emitting device of Embodiment 1 and the outside of the nitride semiconductor light-emitting device.
FIG. **5(a)** is a perspective view of Embodiment 2. FIG. **5(b)** is a cross-sectional view of Embodiment 2 taken along an incidence plane.
FIG. **6(a)** is a perspective view of Embodiment 3. FIG. **6(b)** is a cross-sectional view of Embodiment 3 taken along an incidence plane.
FIG. **7(a)** is a perspective view of Embodiment 4. FIG. **7(b)** is a cross-sectional view of Embodiment 4 taken along an incidence plane.
FIG. **8(a)** is a perspective view of Embodiment 5. FIG. **8(b)** is a cross-sectional view of Embodiment 5 taken along an incidence plane.
FIG. **9(a)** is a perspective view of Embodiment 6. FIG. **9(b)** is a cross-sectional view of Embodiment 6 taken along an incidence plane.
FIG. **10(a)** is a perspective view of Embodiment 7. FIG. **10(b)** is a cross-sectional view of Embodiment 7 taken along an incidence plane.
FIG. **11** is a graph showing the characteristics of transmitted light in Embodiment 1.
FIG. **12** is a graph showing the characteristic of the polarization degree in Embodiment 1.
FIG. **13** is a graph showing the characteristic of the normalized polarization degree in Embodiment 1.
FIG. **14** is a graph showing the characteristics of the phase difference of the polarization components in Embodiment 1.
FIG. **15** is a graph showing the refractive index dependence of the normalized polarization degree in Embodiment 1.
FIG. **16** is a graph showing the relationship between the refractive index of the transparent encapsulating member and the normalized polarization degree in Embodiment 1.
FIG. **17** is a graph showing the relationship between the angle between the symmetry plane of the transparent encapsulating member and the polarization direction of the nitride semiconductor light-emitting element and the normalized polarization degree in Embodiment 1.
FIGS. **18(a)** to **18(c)** are diagrams showing a nitride semiconductor light-emitting device of Embodiment 8.
FIGS. **19(a)** to **19(c)** are diagrams showing a nitride semiconductor light-emitting device of Embodiment 9.
FIGS. **20(a)** to **20(c)** are diagrams showing a nitride semiconductor light-emitting device of Embodiment 10.
FIGS. **21(a)** to **21(c)** are diagrams showing a nitride semiconductor light-emitting device of Embodiment 11.
FIGS. **22(a)** to **22(c)** are diagrams showing another nitride semiconductor light-emitting device of Embodiment 11.
FIGS. **23(a)** to **23(c)** are diagrams showing a nitride semiconductor light-emitting device of Embodiment 12.
FIGS. **24(a)** to **24(c)** are diagrams showing a nitride semiconductor light-emitting device of another embodiment.
FIG. **25** is a diagram showing a measurement system for the polarization degree.
FIG. **26** shows the positional relationship between the shape of the transparent encapsulating member and the nitride semiconductor light-emitting element in Example 1.
FIG. **27** is a graph showing the relationship between the angle between the symmetry plane of the transparent encapsulating member and the polarization direction of the nitride semiconductor light-emitting element and the normalized polarization degree in Example 1.

## DESCRIPTION OF EMBODIMENTS

The inventors of the present application conducted detailed research on the case where a nitride semiconductor light-emitting element is covered with a transparent encapsulating member and examined how the polarization degree of polarized light of the nitride semiconductor light-emitting element depends on the shape of the transparent encapsulating member when the polarized light is transmitted through the surface of the transparent encapsulating member to the outside. Part of the polarized light is reflected at the surface of the transparent encapsulating member, i.e., the interface between the transparent encapsulating member and the outside (air), while the remaining part is transmitted through the interface. Here, the transmittance and the reflectance of the polarized light at this interface depend on the polarization direction of the polarized light. As a result of the research conducted by the inventors of the present application, it was found that these transmittance and reflectance depend on the relationship between the polarization direction of the polarized light generated in the active layer of the nitride semiconductor light-emitting element and the shape of the emission surface. Based on this knowledge, the shape of the transparent encapsulating member and the method of arranging the nitride semiconductor light-emitting element which enable reduction of the polarization degree of light radiated from the nitride semiconductor light-emitting element were conceived.

Hereinafter, embodiments of the present invention will be described with reference to the drawings. In the drawings mentioned below, for the sake of simple description, elements which perform substantially the same functions are denoted by the same reference numerals. Note that the present invention is not limited to the embodiments which will be described below.

(Embodiments 1)

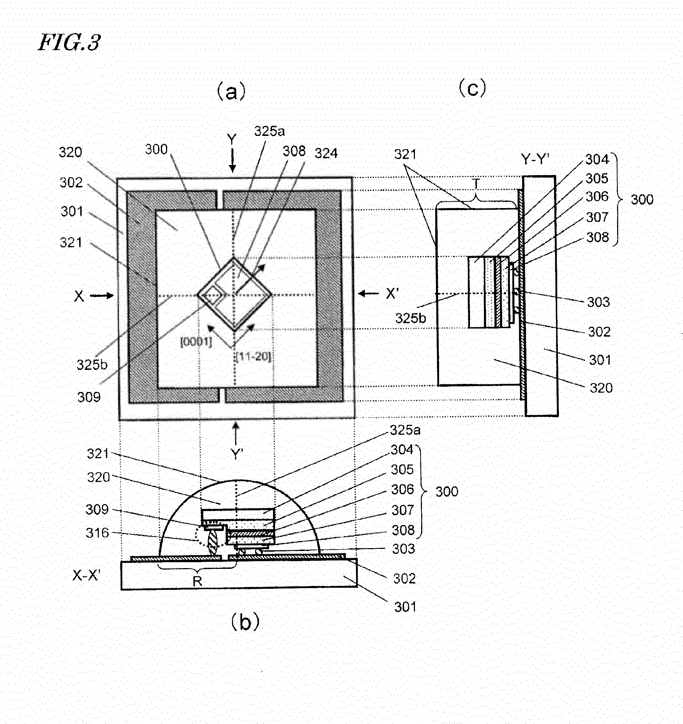

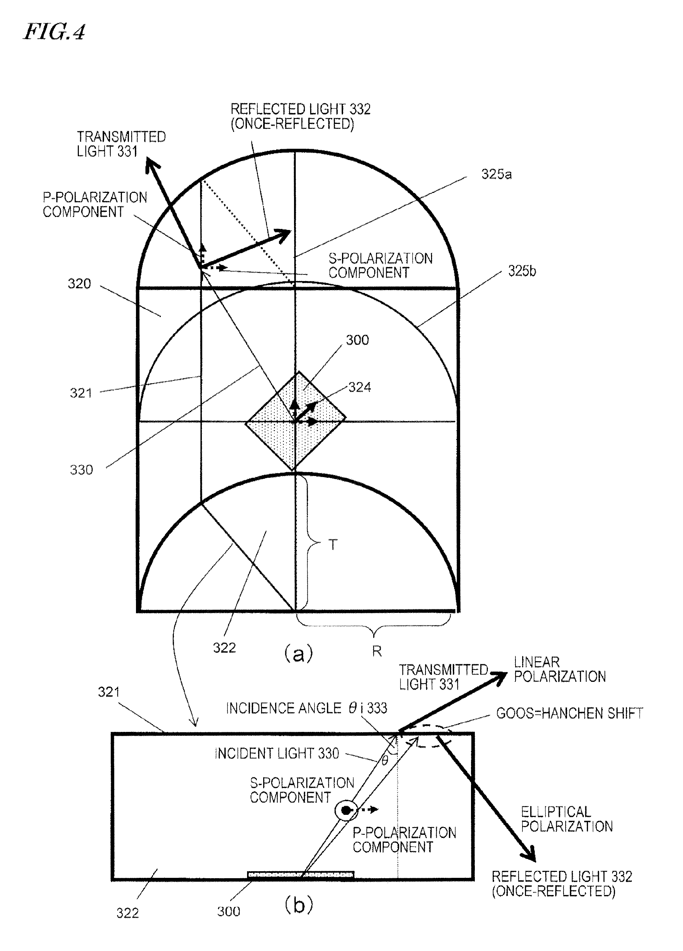

The first embodiment of the nitride semiconductor light-emitting device of the present invention is described with reference to FIG. **3** and FIG. **4.**

Firstly, refer to FIGS. **3(a)** to **3(c).** FIG. **3(a)** is a top view schematically showing a nitride semiconductor light-emitting device of the embodiment of the present invention. FIG. **3(b)** is a cross-sectional view taken along line **X-X'** of FIG. **3(a)** FIG. **3(c)** is a cross-sectional view taken along line **Y-Y'** of FIG. **3(a).**

The nitride semiconductor light-emitting device of the present embodiment includes a surface emission type nitride semiconductor light-emitting element **300** that is configured to emit from the active layer polarized light which is polarized in a polarization direction which is included in a plane parallel to the active layer, and a transparent encapsulating member **320** that is provided so as to cover the nitride semiconductor light-emitting element **300** and that has a symmetry plane which is perpendicular to the active layer. The nitride semiconductor light-emitting element **300** is configured such that its polarization direction is inclined by an angle which does not include 0° or 90° with respect to the symmetry plane of the transparent encapsulating member **320.**

Hereinafter, the present embodiment is described in more detail.

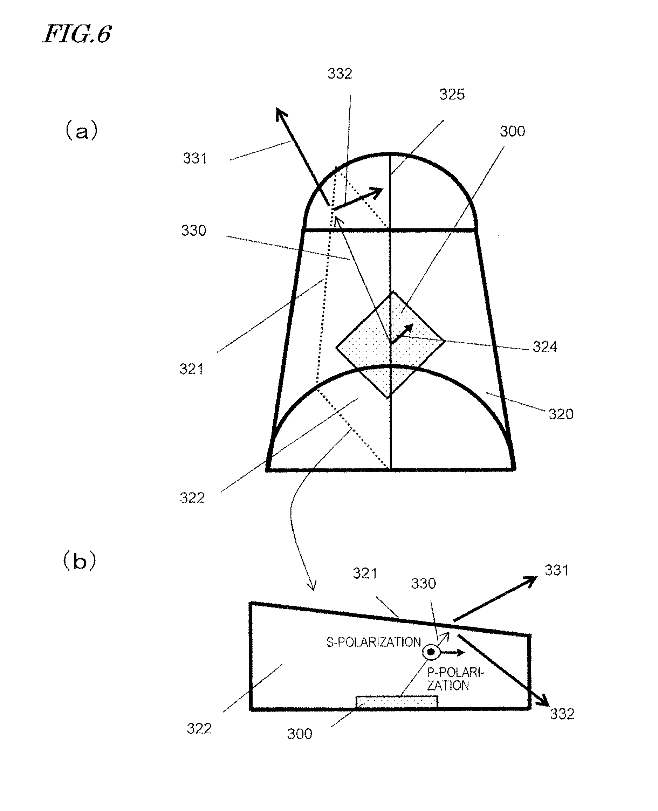

The nitride semiconductor light-emitting element **300** is electrically coupled to a wire **302** which is provided on a mounting base **301** via a bump **303.** The transparent encapsulating member **320** is provided so as to cover the entirety of the nitride semiconductor light-emitting element **300.** The transparent encapsulating member **320** of the present embodiment has a shape which constitutes part of a semicylinder, i.e., a cylindrical shape. In the present specification, the "cylindrical shape" has one or two symmetry planes. When the transparent encapsulating member **320** is cut out using a plane which is perpendicular to either one of the symmetry planes and which is perpendicular to the principal surface or the active layer of the nitride-based semiconductor light-emitting element **300,** the shape of the interface between the transparent encapsulating member **320** and its outside is equal to a cut-out portion of a circular arc. An example where the number of symmetry planes of the cylindrical shape is one is shown in FIG. **6** (Embodiment 3), which will be described later in detail.

The specific structure of the nitride semiconductor light-emitting element **300** of the present embodiment is not particularly limited, so long as it includes an element which has a polarization characteristic. The nitride semiconductor light-emitting element **300** includes, for example, a substrate **304** which includes an $m$-plane GaN layer at least in its surface, a n-type nitride semiconductor layer **305** which is formed on the $m$-plane GaN layer, a nitride semiconductor active layer **306,** a p-type nitride semiconductor layer **307,** a p-side electrode **308** which is provided so as to be in contact with the p-type nitride semiconductor layer **307,** and a n-side electrode **309** which is provided so as to be in contact with the n-type nitride semiconductor layer **305.** Here, the nitride semiconductor refers to a GaN-based semiconductor and to, more specifically, an $Al_xInyGa_zN$ (x+y+z=1, x≥0, y≥0, z≥0) semiconductor.

The "$m$-plane" includes not only a plane which is perfectly parallel to the $m$-plane but also a plane which is inclined by an angle of ±5° or less with respect to the $m$-plane. With just a slight incline with respect to the $m$-plane, the effect of the spontaneous electrical polarization is very small. On the other hand, according to the crystal growth technology, epitaxial growth of a semiconductor layer is easier on a substrate in which the crystal orientation is slightly inclined rather than on a substrate in which the crystal orientation is strictly identical. Thus, in some cases, it may be preferred to incline the crystal plane for the purpose of improving the quality of a semiconductor layer which is to be epitaxially grown or increasing the crystal growth rate, while the effect of the spontaneous electrical polarization is decreased.

The substrate **304** may be an *m*-plane GaN substrate or may be an *m*-plane SiC substrate which includes an *m*-plane GaN layer on its surface or a r-plane or *m*-plane sapphire substrate which includes an *m*-plane GaN layer on its surface. The most important aspect is that light radiated from the active layer is polarized in a specific direction.

The plane orientation of the active layer is not limited to the *m*-plane but only needs to be a non-polar plane or a semi-polar plane. An example of the non-polar plane is *a*-plane. Examples of the semi-polar plane are -r plane and (11-22) plane.

As previously described, a nitride semiconductor active layer formed on the *m*-plane mainly emits light whose electric field intensity is deviated in a direction parallel to the *a*-axis. A nitride semiconductor active layer formed on the *a*-plane mainly emits light whose electric field intensity is deviated in a direction parallel to the *m*-axis. A nitride semiconductor active layer formed on the (11-22) plane, which is a semi-polar plane, mainly emits light whose electric field intensity is deviated in a direction parallel to the *m*-axis, when the mole fraction of In in the nitride semiconductor active layer is small but mainly emits light whose electric field intensity is deviated in a direction parallel to the [-1-123] direction when the mole fraction of In in the nitride semiconductor active layer is large. The polarization characteristic of the nitride semiconductor active layer **306** provided on such a semi-polar plane depends on the behaviors of the upper two of the valence bands (A band and B band) and varies according to the amount of strain imposed on the nitride semiconductor active layer **306** or the quantum confinement effect in some cases.

Although not particularly illustrated in the drawings, an undoped GaN layer may be provided between the nitride semiconductor active layer **306** and the p-type nitride semiconductor layer **307.**

The n-type nitride semiconductor layer **305** is made of, for example, n-type $Al_uGa_vIn_wN$ (u+v+w=1, u$\geq$0, v$\geq$0, w$\geq$0). The n-type dopant used may be, for example, silicon (Si). The p-type nitride semiconductor layer **307** is made of, for example, a p-type $Al_sGa_tN$ (s+t=1, s$\geq$0, t$\geq$0) semiconductor. As the p-type dopant, for example, Mg is added. Examples of the p-type dopant other than Mg are Zn and Be. In the p-type nitride semiconductor layer **307,** the mole fraction of Al, s, may be uniform along the thickness direction. Alternatively, the Al mole fraction s may vary either continuously or stepwise along the thickness direction. Specifically, the thickness of the p-type nitride semiconductor layer **307** is, for example, about 0.05 to 2 $\mu$m.

Part of the p-type nitride semiconductor layer 307 near the upper surface, i.e., near the interface with the p-side electrode **308,** is preferably made of a semiconductor whose Al mole fraction s is zero, i.e., GaN. Also, in this case, it is preferred that the GaN contains a p-type impurity with high concentration and functions as a contact layer.

The nitride semiconductor active layer **306** has a GaInN/GaInN multi-quantum well (MQW) structure in which, for example, $Ga_{1-x}In_xN$ well layers, each having a thickness of about 3 to 20 nm, and $Ga_{1-y}In_yN$ well layers (0$\leq$y<x<1) barrier layers, each having a thickness of about 5 to 30 nm, are alternately stacked one upon the other.

The wavelength of light emitted from the nitride semiconductor light-emitting element **300** depends on the mole fraction of In, x, in the $Ga_{1-x}In_xN$ semiconductor that is the semiconductor composition of the above-described well layers. A piezoelectric field would not be generated in the nitride semiconductor active layer **306** formed on the *m*-plane. Therefore, decrease of the luminous efficacy can be prevented even when the In mole fraction is increased.

The n-side electrode **309** has, for example, a multilayer structure of a Ti layer and a Pt layer (Ti/Pt). It is preferred that the p-side electrode **308** generally covers the entire surface of the p-type nitride semiconductor layer **307.** The p-side electrode **308** has, for example, a multilayer structure of a Pd layer and a Pt layer (Pd/Pt).

Next, the transparent encapsulating member **320** is described.

The Transparent encapsulating member **320** may be made of a resin material, such as a silicone resin or an epoxy resin or an inorganic material, such as glass, sapphire or ZnO. The transparent encapsulating member **320** has a shape which is symmetrical about a plane which is perpendicular to the active layer of the nitride semiconductor light-emitting element **300** (symmetry plane). More specifically, the external shape of the transparent encapsulating member **320** of the present embodiment has a cylindrical shape. The cylindrical shape shown in FIG. **3** is a half of a circular cylinder and has two symmetry planes **325a** and **325b.** These two symmetry planes **325a** and **325b** intersect with each other at right angles. The height *T* and the radius R of the cylindrical shape are equal to each other.

The polarization direction **324** of the nitride semiconductor light-emitting element **300** is inclined by an angle which does not include 0° or 90° (an angle of 0° to 90°) with respect to the symmetry planes **325a** and **325b.** The polarization direction **324** of the nitride semiconductor light-emitting element **300** may be inclined by an angle of not less than 25° and not more than 65° with respect to the symmetry planes **325a** and **325b.** This inclination angle may be not less than 35° and not more than 55°. For example, when the polarization direction **324** of the nitride semiconductor light-emitting element **300** is inclined by 30° with respect to the symmetry plane **325a,** the polarization direction **324** has an inclination of 60° with respect to the symmetry plane **325b.** Therefore, this angular range is always satisfied. This is because the two symmetry planes **325a** and **325b** intersect with each other at right angles.

When the polarization direction **324** of the nitride semiconductor light-emitting element **300** is inclined by 35° to 55° with respect to the symmetry planes **325a** and **325b,** the normalized polarization degree can be decreased to about 0.4. When the polarization direction **324** of the nitride semiconductor light-emitting elements **300** is inclined by 37° to 53° with respect to the symmetry planes **325a** and **325b,** the normalized polarization degree can be decreased to about 0.3. Here, the normalized polarization degree refers to a value obtained by normalizing the polarization degree defined by Formula 1 with the polarization degree of the nitride semiconductor light-emitting element **300**.

The length of the shortest part of the transparent encapsulating member **320** is preferably not less than the length of the longest part of the nitride semiconductor light-emitting element **300**. The shortest part of the transparent encapsulating member **320** refers to the length of the shortest distance between the intersection of the diagonal lines of a quadrangle which is obtained by orthogonal projection of the shape of the nitride semiconductor light-emitting element **300** onto the mounting base **301** and the interface **321** between the transparent encapsulating member **320** and its outside. When the top view of the nitride semiconductor light-emitting element **300** has a square or rectangular shape, the length of the diagonal line of the square or rectangular shape is the longest part of the nitride semiconductor light-emitting element **300**.

The ratio of the length of the shortest part of the transparent encapsulating member **320** to the length of the longest part of the nitride semiconductor light-emitting element **300** is preferably greater than the refractive index of the transparent encapsulating member **320**. For example, when the cross-sectional shape of the surface of the transparent encapsulating member **320** is close to a circular arc, light emitted from the nitride semiconductor light-emitting element **300** is less likely to undergo total reflection at the surface of the transparent encapsulating member **320**.

Next, the state of polarization of transmitted light and reflected light at the surface of the transparent encapsulating member **320** is described with reference to FIGS. **4(a)** and **4(b)**. FIG. **4(a)** is a bird's-eye view of the transparent encapsulating member **320**. FIG. **4(b)** is a cross-sectional view taken along the incidence plane of arbitrary light (incident light **330**). In FIG. **4,** respective layers of the nitride semiconductor light-emitting element **300** and the mounting base **301** are omitted because a ray of light is considered.

Light emitted from the nitride semiconductor light-emitting element **300** passes through the transparent encapsulating member **320** and goes out through the surface of the transparent encapsulating member **320** to the outside (e.g., air). The surface of the transparent encapsulating member **320** forms the interface between the transparent encapsulating member **320** and its outside. Thus, the surface of the transparent encapsulating member **320** is simply referred to as "interface". At this interface, there is a difference in refractive index, so that reflection or refraction of light can occur.

Light emitted from the nitride semiconductor light-emitting element **300** travels inside the transparent encapsulating member **320** and enters on the interface **321**. Of the incident light **330** on the interface **321,** there are a component which is transmitted through the interface **321** (transmitted light **331)** and a component which is reflected by the interface **321** (reflected light **332)**. The incidence plane **332** refers to a plane which is formed by the incident light **330,** the transmitted light **331,** and the reflected light **332**. An angle formed by the incident light **330** with respect to a direction perpendicular to the interface **321** is referred to as "incidence angle **333"**.

According to the configuration of the present embodiment, the polarization direction **324** of the nitride semiconductor light-emitting element **300** is inclined by an angle which does not include 0° or 90° (an angle of greater than 0° and smaller than 90°) with respect to the symmetry planes **325a** and **325b.** Therefore, the incident light **330** includes an S-polarization component and a P-polarization component with respect to the incidence plane **332.**

The nitride semiconductor light-emitting element **300** is preferably placed such that at least part of the nitride semiconductor light-emitting element **300** is present on the symmetry plane **325a** or the symmetry plane **325b.** More preferably, the nitride semiconductor light-emitting element **300** is placed such that at least part of the nitride semiconductor light-emitting element 300 is present on the intersecting line of the symmetry plane **325a** and the symmetry plane **325b.** Still more preferably, the nitride semiconductor light-emitting element **300** is placed such that the center of the nitride semiconductor light-emitting element **300** is present on the intersecting line of the symmetry plane **325a** and the symmetry plane **325b.** When the top view of the nitride semiconductor light-emitting element **300** has a square or rectangular shape, for example, the center of the nitride semiconductor light-emitting element **300** means the intersection of the diagonal lines of the square or rectangular shape. Thus, placing the nitride semiconductor light-emitting element **300** on the symmetry plane also improves the symmetry of the light distribution pattern of light extracted from the transparent encapsulating member **320.**

The nitride semiconductor light-emitting element **300** is smaller than the transparent encapsulating member **320** and therefore can be regarded as substantially a point light source. Since it is substantially a point light source, it is assumed that the intensity distribution of light from the nitride semiconductor light-emitting element **300** has a Lambertian shape (the intensity of emission is the strongest in the M-axis direction, and the intensity in a direction which is inclined by θ with respect to the M-axis is cosθ).

Light which is incident on the interface **321** at an angle which is smaller than the critical angle that is determined according to Snell's law ($\theta=\sin^{-1}(n2/n1)$), where n1 is the refractive index of the transparent encapsulating member **320** and n2 is the refractive index of the outside of the transparent encapsulating member **320,** is intense and is therefore transmitted through the interface **321**. Light which is incident on the interface **321** at an angle which is equal to or greater than the critical angle θi is reflected by the interface **321**. Hereinafter, the effects of the present embodiment will be described separately for the transmitted light and the reflected light.

<Transmitted Light>

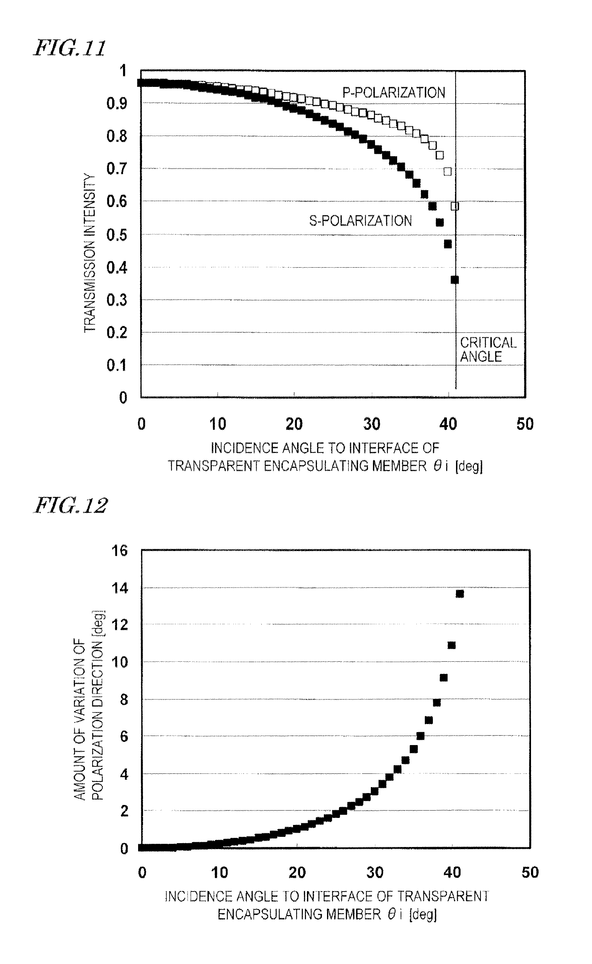

Almost all part of light whose incidence angle **333** is smaller than the critical angle passes through the interface **321**. FIG. **11** is a graph showing the calculation results of the incidence angle **333** to the interface **321** and the transmission intensity of the S-polarization component (the component perpendicular to the incidence plane) and the P-polarization component (the component parallel to the incidence plane) where the refractive index of the transparent encapsulating member **320** was 1.5, and the refractive index of the outside of the transparent encapsulating member **320** was 1. The transmission intensity of "1" means all part of the incident light passes through the interface. The reason why the transmission intensity is not 1 when the incidence angle is 0 is that there is reflected light. When the incidence angle **333** increases (approaches to the critical angle), the S-polarization component is less likely to pass through the interface, while the P-polarization component is intense and is therefore transmitted through the interface. As a result, such a phenomenon occurs that the polarization direction rotates in a direction parallel to an incidence plane **322**.

FIG. **12** is a graph showing the calculation results of the incidence angle **333** to the interface **321** and the amount of variation of the polarization direction (the amount of variation from the original polarization direction) where the refractive index of the transparent encapsulating member **320** was 1.5, and the refractive index of the outside of the transparent encapsulating member **320** was 1. It is appreciated that, as the incidence angle **333** increases (approaches to the critical angle), the polarization direction of the transmitted light, i.e., the plane of polarization, greatly varies.

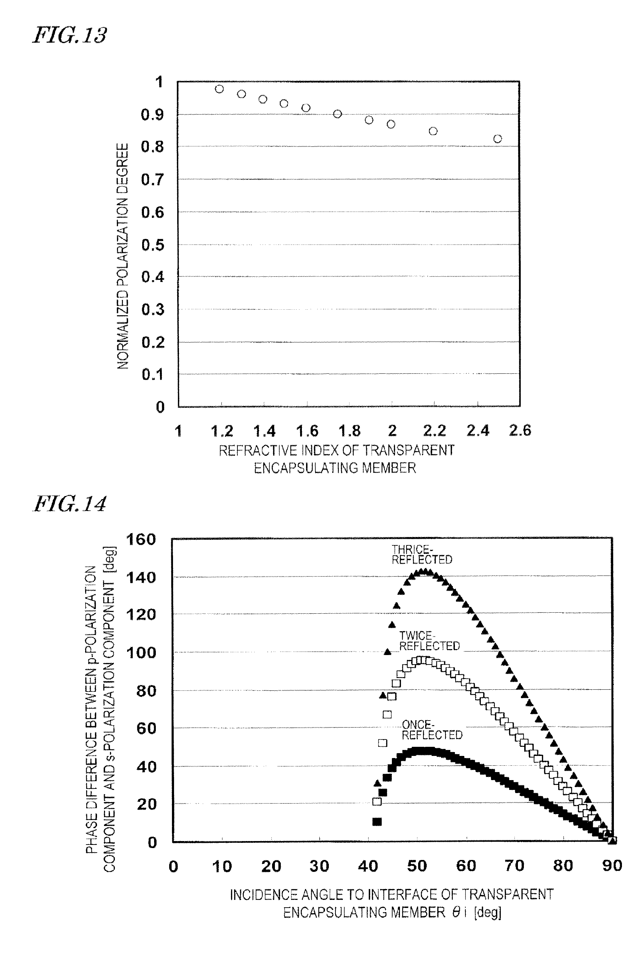

FIG. **13** is a graph showing the calculation results of the normalized polarization degree with respect to the refractive index of the transparent encapsulating member **320** where the refractive index of the outside of the transparent encapsulating member **320** was 1, and the angle formed between the polarization direction **324** of the nitride semiconductor light-emitting element and the symmetry plane of the transparent encapsulating member **320** was 45°. Here, the calculation of the polarization degree was realized by integration of light whose incidence angle **333** was in the range from 0° to the critical angle. Here, the normalized polarization degree refers to a value which was normalized with the polarization degree of the nitride semiconductor light-emitting element **300**. The calculation was carried out on the assumption that the polarization degree of the nitride semiconductor light-emitting element **300** was 1, although the actual polarization degree of the nitride semiconductor light-emitting element **300** depends on the In mole fraction of the nitride semiconductor active layer **306**. It is appreciated from FIG. **13** that the effect of reducing the polarization degree also depends on the refractive index of the transparent encapsulating member **320**. That is, it is appreciated that, as the refractive index of the transparent encapsulating member **320** increases, the polarization degree of the transmitted light decreases. Although the refractive index of a silicone resin and an epoxy resin which are widely used as a common material for the encapsulating member is about 1.4 to 1.5, it is appreciated that the effects of the invention of the present application can also be achieved with the silicone resin or the epoxy resin.

One of the characteristics of the transmitted light is that there is no phase difference between the S-polarization component and the P-polarization component. Specifically, when the incident light on the interface **321** is perfectly linearly-polarized light, considering only an arbitrary ray of the light, linear polarization is still maintained in the transmitted light. However, actual light from a nitride semiconductor light-emitting device is the sum of light extracted out of the transparent encapsulating member **320**. Therefore, when light whose incidence angle **333** is in the range from 0° to the critical angle are integrated, the polarization degree can be decreased.

<Reflected Light>

Almost all part of light whose incidence angle **333** is equal to or greater than the critical angle is reflected by the interface **321**. This is because the refractive index of the transparent encapsulating member **320** is greater than the refractive index of its outside (1 in the case of air). When light is reflected, the light permeates out by a distance which is approximately equal to its wavelength, so that such a phenomenon that the point of reflection on the surface shifts (Goos-Haenchen shift) occurs. As a result, a phase difference is produced between the S-polarization component and the P-polarization component.

FIG. **14** shows the phase difference between the S-polarization component and the P-polarization component where the refractive index of the transparent encapsulating member **320** was 1.5, and the refractive index of the outside of the transparent encapsulating member **320** was 1. In the graph, the phase differences in once-reflected light, twice-reflected light, and thrice-reflected light are shown. In FIG. **14,** only the once-reflected light **332** is shown, although actual light includes a light component which is reflected a plurality of times. In the case where the incident light **330** is perfectly linearly-polarized light, the reflected light **332** is circular polarization when the phase difference is 90 · (2m+1), and otherwise, it is elliptical polarization. Here, m is an integer. The reflected light **332** is circular polarization only when the light is incident on the interface **321** at a specific angle.

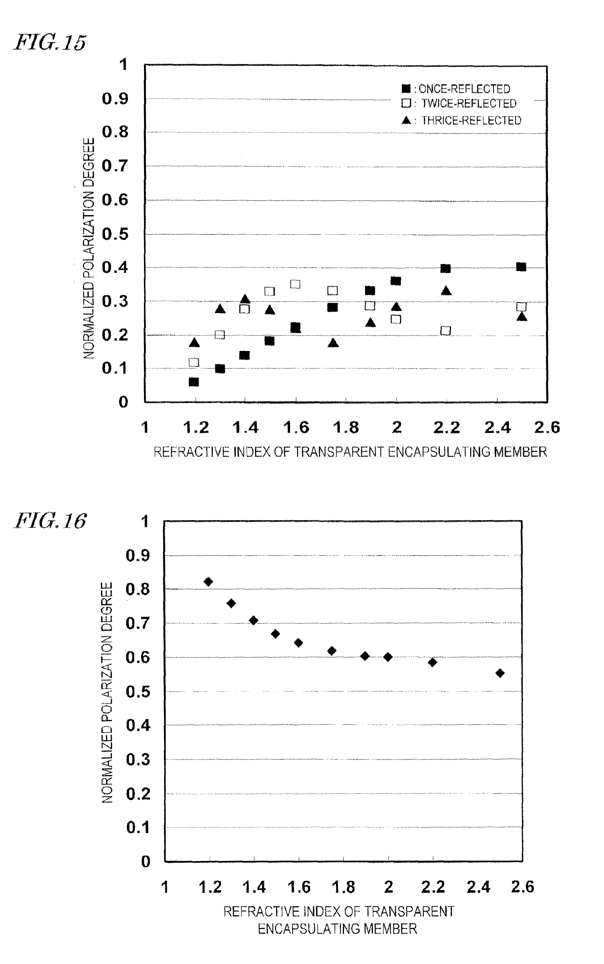

FIG. **15** is a graph showing the calculation results of the normalized polarization degree with respect to the refractive index of the transparent encapsulating member **320** where the refractive index of the outside of the transparent encapsulating member **320** was 1, and the angle formed between the polarization direction **324** of the nitride semiconductor light-emitting element and the symmetry plane of the transparent encapsulating member **320** was 45°. Here, the calculation of the polarization degree was realized by integration of light whose incidence angle **333** was in the range from the critical angle to 90°. The normalized polarization degree refers to a value which was normalized with the polarization degree of the nitride semiconductor light-emitting element **300**. The calculation was carried out on the assumption that the polarization degree of the nitride semiconductor light-emitting element **300** was 1. As for the once-reflected light, the decrease of the normalized polarization degree becomes greater as the refractive index decreases. It is also appreciated that the number of peaks and troughs increases as the number of reflections increases. In the case of two or more reflections, the normalized polarization degree is not more than 0.4.

When the shape of the transparent encapsulating member **320** is a hemispherical shape which is commonly employed, it is designed so as to prevent total reflection at the interface **321**. Therefore, the effect of reducing the polarization degree which is attributed to such reflected light is small and is out of consideration. In the present configuration, the shape of the transparent encapsulating member **320** and the polarization direction of the nitride semiconductor light-emitting element **300** are appropriately determined such that reflection occurs one or more times inside the transparent encapsulating member **320,** and the light is converted to circular polarization or elliptical polarization before extracted to the outside.

As described above, one of the characteristics of the reflected light is that a phase difference occurs between the S-polarization component and the P-polarization component. That is, even when the incident light on the interface **321** is perfectly linearly-polarized light, the reflected light **332** is converted to circularly-polarized light or elliptically-polarized light in the present configuration, so that the polarization degree can be decreased.

<Transmitted Light and Reflected Light>

FIG. **16** is a graph showing the calculation results of the normalized polarization degree with respect to the refractive index of the transparent encapsulating member **320** where the refractive index of the outside of the transparent encapsulating member **320** was 1, and the angle formed between the polarization direction **324** of the nitride semiconductor light-emitting element **300** and the symmetry plane of the transparent encapsulating member **320** was 45°. The graph of FIG. **16** shows the calculation results of the refractive index of the transparent encapsulating member **320** and the normalized polarization degree in which both the transmitted light and the once-reflected light were considered. Here, the normalized polarization degree refers to a value which was normalized with the polarization degree of the nitride semiconductor light-emitting element **300**. The calculation was carried out on the assumption that the polarization degree of the nitride semiconductor light-emitting element **300** was 1. As the refractive index of the transparent encapsulating member **320** increases, the polarization degree can be further decreased.

Now, light is described for the case where the incidence plane **322** is identical with the bottom surface of the transparent encapsulating member **320**. When the incidence plane **322** is identical with the bottom surface of the transparent encapsulating member **320,** the polarization direction **324** of the nitride semiconductor light-emitting element **300** is present in the incidence plane **322,** and there is only the P-polarization component. Therefore, light emitted in this direction only includes the P-polarization component, so that the polarization degree of the transmitted light **331** and the reflected light **332** would not decrease. However, actual light radiated from the nitride semiconductor light-emitting element **300** has such a characteristic that intense light is emitted in a direction perpendicular to the principal surface of the nitride semiconductor light-emitting element **300,** while the intensity of the light in a direction which is inclined by θ with respect to the principal surface generally decreases to an intensity of cosθ. Thus, the amount of light whose incidence plane **322** is identical with the bottom surface of the transparent encapsulating member **320** is sufficiently small as compared with the total amount of light of the nitride semiconductor light-emitting device. In the present configuration, the effect of reducing the polarization degree can be achieved.

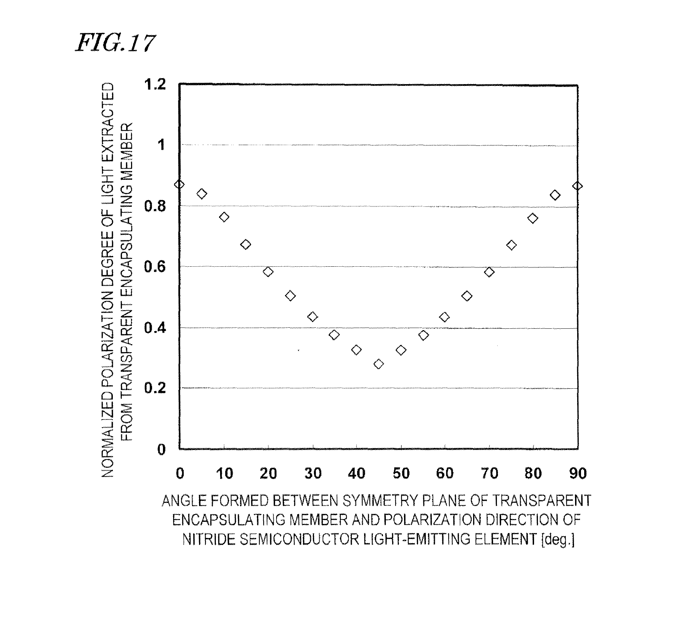

FIG. **17** shows the relationship (calculated values) between the angle formed between the symmetry plane of the transparent encapsulating member **320** and the polarization direction of the nitride semiconductor light-emitting element **300** and the normalized polarization degree of light extracted from the transparent encapsulating member **320**. The shape of the transparent encapsulating member **320** is the cylindrical shape of FIG. **4.** It is herein assumed that the nitride semiconductor light-emitting element **300** is placed on the intersecting line of the symmetry plane **325a** and the symmetry plane **325b**. Here, the normalized polarization degree refers to a value which was normalized with the polarization degree of the nitride semiconductor light-emitting element **300.** The calculation was carried out on the assumption that the polarization degree of the nitride semiconductor light-emitting element **300** was 1. When the angle formed between the symmetry plane **325a, 325b** of the transparent encapsulating member **320** and the polarization direction of the nitride semiconductor light-emitting element **300** is 45°, the normalized polarization, degree is the smallest. It is appreciated that, when the angle formed between the symmetry plane of the transparent encapsulating member **320** and the polarization direction of the nitride semiconductor light-emitting element **300** is in the range of 25° to 65°, the normalized polarization degree can be reduced to 0.5. It is also appreciated that, when this angle is in the range of 35° to 55°, the normalized polarization degree can be reduced to 0.38.

Next, a manufacturing method of the present embodiment is described with reference to FIG. **3.**

Firstly, described is an example of the manufacturing method of the nitride semiconductor light-emitting element **300.**

On an n-type GaN substrate **304** having an *m*-plane principal surface, an n-type nitride semiconductor layer **305** is epitaxially grown using an MOCVD method. For example, an n-type nitride semiconductor layer **305** which is made of GaN and which has a thickness of about **1** to 3 $\mu$m is formed at a growth temperature of not less than 900°C and not more than 1100°C, using silicon as the n-type impurity, while TMG (Ga(CH$_3$)$_3$) and NH$_3$ are supplied as the source materials.

Then, a nitride semiconductor active layer **306** is formed on the n-type nitride semiconductor layer **305.** The nitride semiconductor active layer **306** has a GaInN/GaN multi-quantum well (MQW) structure in which, for example, 15 nm thick Ga$_{1-x}$In$_x$N well layers and 30 nm thick GaN barrier layers are alternately stacked one upon the other. In forming the Ga$_{1-x}$In$_x$N well layers, decreasing the growth temperature to 800°C is preferred for taking In inside.

The emission wavelength is selected according to the use for the nitride-based semiconductor light-emitting element **300,** and the In mole fraction x is determined according to the wavelength. When the wavelength is 450 nm (blue), the In mole fraction x is determined as 0.18 to 0.2. When the wavelength is 520 nm (green), x=0.29 to 0.31. When the wavelength is 630 nm (red), x=0.43 to 0.44.

On the nitride semiconductor active layer **306,** an undoped GaN layer which has a thickness of, for example, 15 to 50 nm may be deposited (although not shown). On the undoped GaN layer, a p-type nitride semiconductor layer **307** is formed. For example, a p-type nitride semiconductor layer **307** which has a thickness of about 50 to 300 nm and which is made of p-type GaN is formed at a growth temperature of not less than 900°C and not more than 1100°C, using Cp$_2$Mg (cyclopentadienyl magnesium) as the p-type impurity, while TMG and NH$_3$ are supplied as the source materials. Inside the p-type nitride semiconductor layer **307,** a p-AlGaN layer which has a thickness of about 15 to 30 nm may be included (although not shown). Providing the p-AlGaN layer enables prevention of an overflow of electrons in operation. Thereafter, a heat treatment is performed at a temperature of about 800 to 900°C for about 20 minutes.

Then, dry etching is performed using a chlorine gas such that the p-type nitride semiconductor layer **307,** the nitride semiconductor active layer **306,** and the n-type nitride semiconductor layer **305** are partially removed to form a recessed portion **316,** whereby part of the n-type nitride semiconductor layer **305** is exposed.

A n-side electrode **309** is formed so as to be in contact with the exposed part of the n-type nitride semiconductor layer **305.** For example, Ti/Pt layers are formed as the n-side electrode **309.** Further, a p-side electrode **308** is formed so as to be in contact with the p-type nitride semiconductor layer **307.** For example, Pd/Pt layers are formed as the p-side electrode **308.** Thereafter, a heat treatment is performed such that the Ti/Pt layers and the n-type nitride semiconductor layer **305** are alloyed together, and the Pd/Pt layers and the p-type nitride semiconductor layer **307** are also alloyed together.

Thereafter, the n-type GaN substrate **304** is ground to about 50 to 300 $\mu$m so as to be a thin film. By conversion to a thin film, dicing becomes easy, and also, absorption of light inside the nitride-based semiconductor light-emitting element **300** can be prevented.

The nitride-based semiconductor light-emitting element **300** that is manufactured as described above is mounted on the mounting base **301.** Here, a flip-chip structure is described.

On the mounting base **301,** the wire **302** is formed in advance. Examples of the material for the mounting base include alumina, AlN, resins. When Si or Ge is used for the mounting base, the surface of the mounting base is preferably covered with an insulating film. The wire **302** may be arranged according to the electrode shape of the nitride-based semiconductor light-emitting element **300.** For the wire **302,** Cu, Au, Ag, or Al may be used. These materials may be provided on the mounting base **301** by sputtering or plating.

A bump **303** is formed on the wire **302.** Au is preferably used for the bump. In forming the Au bump, a Au bump having a diameter of about 50 to 70 $\mu$m may be formed using a bump bonder. Alternatively, the Au bump may also be formed by Au plating. To the mounting base **301** on which the bump **303** has been formed in this way, the nitride-based semiconductor light-emitting element **300** is coupled by ultrasonic bonding.

Then, a transparent encapsulating member **320** is formed. For the transparent encapsulating member **320,** an epoxy resin or a silicone resin may be used. To determine the shape of the transparent encapsulating member **320,** a mold is placed over the mounting base **301** on which the nitride-based semiconductor light-emitting element **300** has been mounted, and a resin is injected into the space between the mold and the mounting base **301.** According to this method, the shaping of the transparent encapsulating member **320** and the resin encapsulation of the nitride-based semiconductor light-emitting element **300** can be performed concurrently. According to a possible alternative method, a transparent encapsulating member **320** having a space left for the nitride-based semiconductor light-emitting element **300** is prepared in advance. The thus-prepared transparent encapsulating member **320** is placed over the mounting base **301** on which the nitride-based semiconductor light-emitting element **300** has been mounted, and then, a resin is injected into the space.

It is desirable that the polarization direction of the nitride-based semiconductor light-emitting element **300** be recognizable from the appearance of the nitride-based semiconductor light-emitting element **300**. For example, based on the shapes of the p-side electrode **308** and the n-electrode **309** shown in FIG. **3(a),** the orientation of the p-side electrode **308** or the n-side electrode **309** is set so as to accord with the c-axis direction and the *a*-axis direction while referring to the orientation flat of the n-type GaN substrate **304** that has the *m*-plane principal surface.

Then, in the condition that the polarization direction (the *a*-axis direction) of the nitride-based semiconductor light-emitting element **300** is recognizable from the shapes of the p-side electrode **308** and the n-side electrode **309,** the orientation of the symmetry plane of the transparent encapsulating member **320** is set so as to accord with a desired angle of the polarization direction of the semiconductor light-emitting element **300**. In the example described herein, the polarization direction of the nitride-based semiconductor light-emitting element **300** is recognizable from the shapes of the electrodes, although it may alternatively be recognizable from the external shape of the nitride-based semiconductor light-emitting element **300**. For example, when the nitride-based semiconductor light-emitting element **300** is cut out so as to have a rectangular shape and is arranged such that the long side direction of the rectangular shape is identical with the *a*-axis direction (the polarization direction), the polarization direction is recognizable from the external shape of the nitride-based semiconductor light-emitting element **300**. Thus, the orientation of the symmetry plane of the transparent encapsulating member **320** can be set so as to accord with a desired angle of the polarization direction of the semiconductor light-emitting element **300**.

The nitride-based semiconductor light-emitting device of the present embodiment is completed according to a method such as described above.

In the above-described example of Embodiment 1, the transparent encapsulating member **320** has a shape which constitutes part of a semicylinder, i.e., a cylindrical shape. The embodiments which will be described below include an embodiment where the transparent encapsulating member **320** has a shape which constitutes part of a circular cone, an embodiment where the transparent encapsulating member **320** has a shape which constitutes part of a polygonal prism, an embodiment where the transparent encapsulating member **320** has a shape which constitutes part of an elliptical sphere, and an embodiment where the transparent encapsulating member **320** has a shape which constitutes part of a rectangular parallelpiped.

(Embodiment 2)

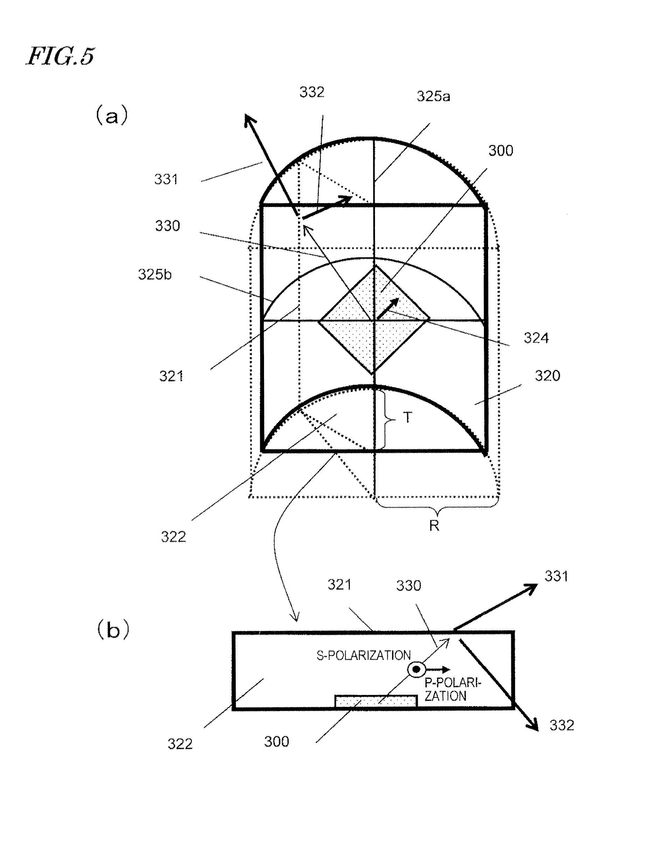

Hereinafter, the second embodiment of the nitride-based semiconductor light-emitting device of the present invention is described with reference to FIG. **5.**

In FIG. **5,** the shape of the transparent encapsulating member **320** and the polarization direction **324** of the nitride-based semiconductor light-emitting element **300** are shown. The respective layers of the nitride semiconductor light-emitting element and the mounting base **301** are not shown. FIG. **5** shows a bird's-eye view (upper part) and a cross-sectional view taken along the incidence plane of an arbitrary ray of light (lower part). The same also applies to FIG. **6** through FIG. **10** which will be described later.

The difference between the embodiment of FIG. **5** and the embodiment of FIG. **4** resides in that the present embodiment satisfies the relationship of T<R where T is the height of the cylindrical shape and R is the radius of the cylindrical shape. The polarization direction **324** of the nitride semiconductor light-emitting element **300** in the present embodiment is also inclined by an angle which does not include 0° or 90° (an angle of 0° to 90°) with respect to the symmetry planes **325a** and **325b**. In the present embodiment, the polarization direction **324** of the nitride semiconductor light-emitting element **300** may also be inclined by an angle of not less than 25° and not more than 65° with respect to the symmetry planes **325a** and **325b**. This inclination angle may be not less than 35° and not more than 55°.

In the present embodiment, the incident light **330** that is incident on the interface **321** includes an S-polarization component and a P-polarization component. As seen from FIG. **5(b),** the incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325a** or the symmetry plane **325b**. More preferably, the nitride semiconductor light-emitting element **300** is placed such that at least part of the nitride semiconductor light-emitting element **300** is present on the intersecting line of the symmetry plane **325a** and the symmetry plane **325b**. Still more preferably, the nitride semiconductor light-emitting element **300** is placed such that the center of the nitride semiconductor light-emitting element **300** is present on the intersecting line of the symmetry plane **325a** and the symmetry plane **325b**. Thus, placing the nitride semiconductor light-emitting element **300** on the symmetry plane also improves the symmetry of the light distribution pattern of light extracted from the transparent encapsulating member **320**.

In the present embodiment, the height of the cylindrical shape, T, is small, and accordingly, the size of the nitride semiconductor light-emitting device can be small. The effect of light absorption in the transparent encapsulating member **320** can be decreased, and in addition, the amount of use of the transparent encapsulating member **320** can be reduced.

(Embodiment 3)

Next, the third embodiment of the nitride-based semiconductor light-emitting device of the present invention is described with reference to FIG. **6.**

The difference between the embodiment of FIG. **6** and the embodiment of FIG. **4** resides in that the radius of the cylindrical shape varies along the depth direction of the drawing sheet. In the present embodiment, the cylindrical shape has one symmetry plane **325.** The polarization direction **324** of the nitride semiconductor light-emitting element **300** is inclined by an angle which does not include 0° or 90° (an angle of 0° to 90°) with respect to the symmetry plane **325.** The polarization direction **324** of the nitride semiconductor light-emitting element **300** may be inclined by an angle of not less than 25° and not more than 65° with respect to the symmetry plane **325.** This inclination angle may be not less than 35° and not more than 55°.

In the present embodiment, the incident light **330** that is incident on the interface **321** also includes an S-polarization component and a P-polarization component. As seen from FIG. **6(b),** the incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325.** More preferably, the nitride semiconductor light-emitting element **300** is placed such that the center of the nitride semiconductor light-emitting element **300** is present on the symmetry plane **325.** Thus, placing the nitride semiconductor light-emitting element **300** on the symmetry plane also improves the symmetry of the light distribution pattern of light extracted from the transparent encapsulating member **320.**

The number of symmetry planes in the transparent encapsulating member **320** of the present embodiment is smaller than in Embodiments 1 and 2. Thus, the design flexibility of the transparent encapsulating member **320** improves.

(Embodiment 4)

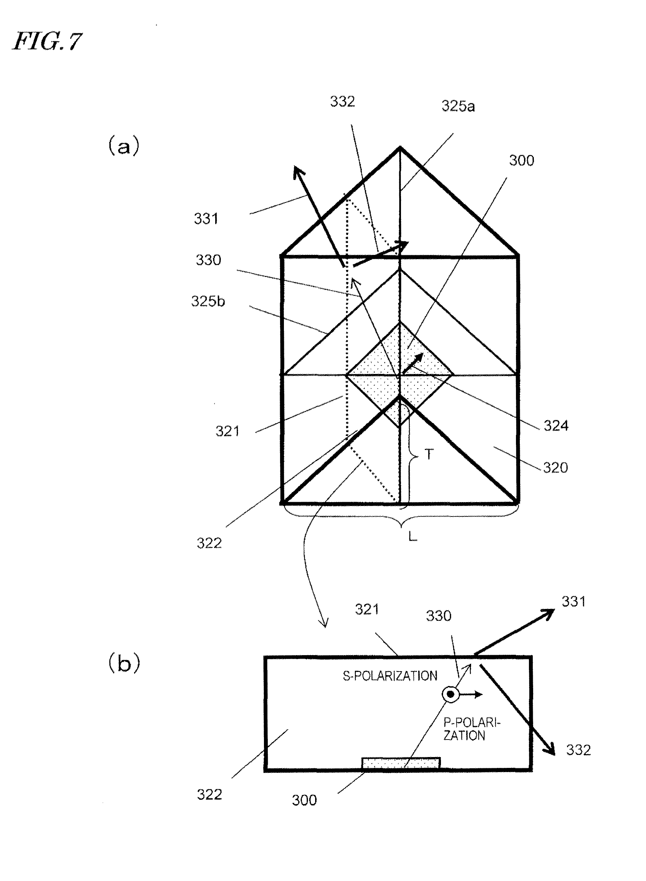

Next, the fourth embodiment of the nitride-based semiconductor light-emitting device of the present invention is described with reference to FIG. **7.**

As shown in FIG. **7(a)** and FIG. **7(b),** in the present embodiment, the transparent encapsulating member **320** has the shape of a triangular prism. A cross section of the transparent encapsulating member **320** has the shape of an isosceles triangle where the height is $T$ and the base is $L$. The transparent encapsulating member **320** of the present embodiment has two symmetry planes **325a** and **325b** which intersect with each other at right angles. The polarization direction **324** of the nitride semiconductor light-emitting element **300** is inclined by an angle which does not include 0° or 90° (an angle of 0° to 90°) with respect to the symmetry planes **325a** and **325b.** The polarization direction **324** of the nitride semiconductor light-emitting element **300** may be inclined by an angle of not less than 25° and not more than 65° with respect to the symmetry planes **325a** and **325b.** This inclination angle may be not less than 35° and not more than 55°.

In the present embodiment, the incident light **330** that is incident on the interface **321** also includes an S-polarization component and a P-polarization component. As seen from FIG. **7(b),** the incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325a** or the symmetry plane **325b.** More preferably, the nitride semiconductor light-emitting element **300** is placed such that at least part of the nitride semiconductor light-emitting element **300** is present on the intersecting line of the symmetry plane **325a** and the symmetry plane **325b.** Still more preferably, the nitride semiconductor light-emitting element **300** is placed such that the center of the nitride semiconductor light-emitting element **300** is present on the intersecting line of the symmetry plane **325a** and the symmetry plane **325b.**

Thus, placing the nitride semiconductor light-emitting element **300** on the symmetry plane also improves the symmetry of the light distribution pattern of light extracted from the transparent encapsulating member **320.**

(Embodiment 5)

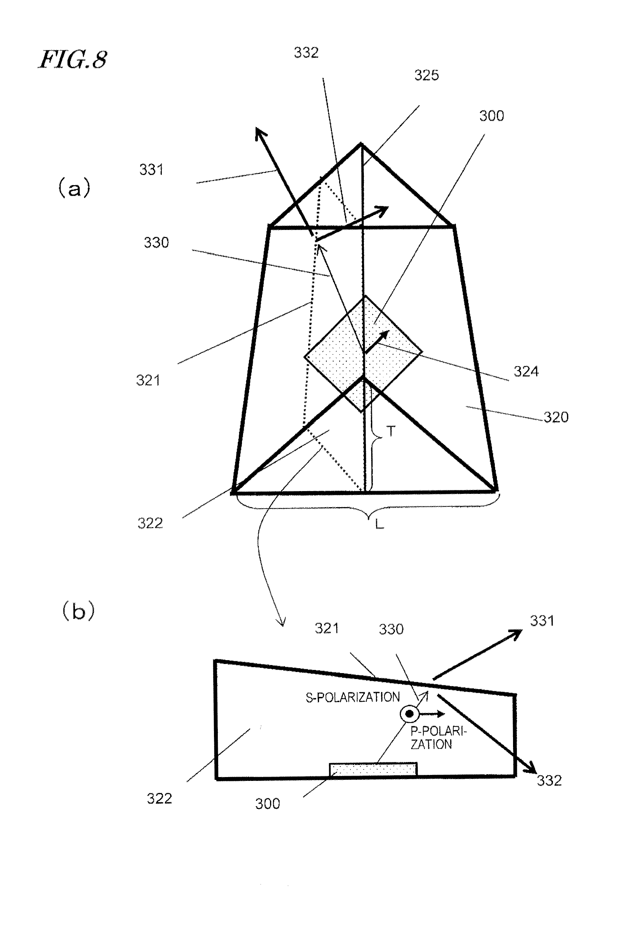

Next, the fifth embodiment of the nitride-based semiconductor light-emitting device of the present invention is described with reference to FIG. **8**.

The difference between the present embodiment and the embodiment shown in FIG. **7** resides in that, in the present embodiment, the ratio of the height *T* to the base *L* of the isosceles triangle of the transparent encapsulating member **320** varies along the depth direction of the drawing sheet. In the present embodiment, the transparent encapsulating member **320** that has the shape of a triangular prism has one symmetry plane **325**. The polarization direction **324** of the nitride semiconductor light-emitting element **300** is inclined by an angle which does not include 0° or 90° (an angle of 0° to 90°) with respect to the symmetry plane **325**. The polarization direction **324** of the nitride semiconductor light-emitting element **300** may be inclined by an angle of not less than 25° and not more than 65° with respect to the symmetry plane **325**. This inclination angle may be not less than 35° and not more than 55°.

In the present embodiment, the incident light **330** that is incident on the interface **321** also includes an S-polarization component and a P-polarization component. As seen from FIG. **8(b),** the incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325**. More preferably, the nitride semiconductor light-emitting element **300** is placed such that the center of the nitride semiconductor light-emitting element **300** is present on the symmetry plane **325**.

Thus, placing the nitride semiconductor light-emitting element **300** on the symmetry plane also improves the symmetry of the light distribution pattern of light extracted from the transparent encapsulating member **320**.

The number of symmetry planes is smaller than in Embodiment 4. Thus, the design flexibility of the transparent encapsulating member **320** improves.

(Embodiment 6)

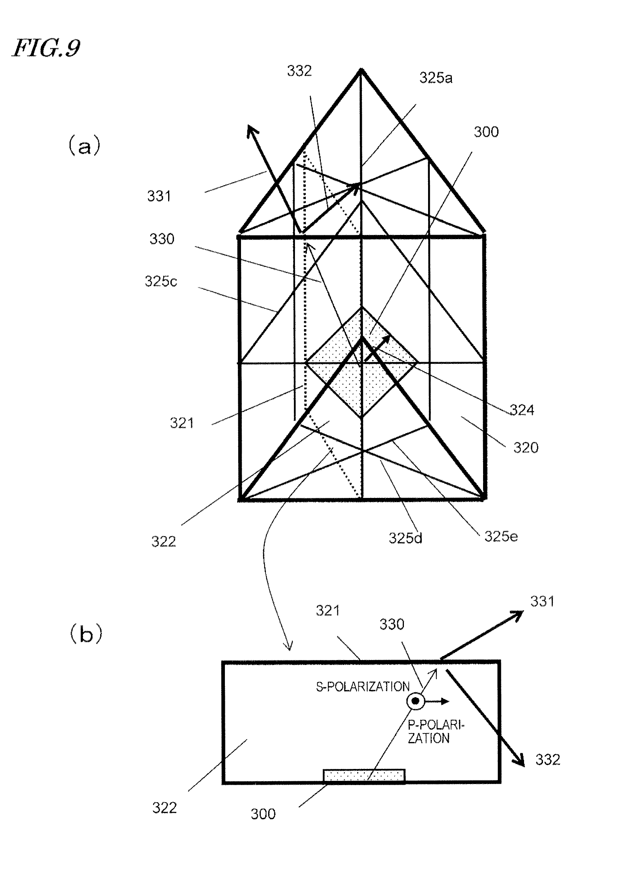

Next, the sixth embodiment of the nitride-based semiconductor light-emitting device of the present invention is described with reference to FIG. **9**.

In the present embodiment, the transparent encapsulating member **320** which has the shape of an equilateral triangular prism has four symmetry planes **325a, 325c, 325d,** and **325e.**

The polarization direction **324** of the nitride semiconductor light-emitting element **300** is inclined by an angle which does not include 0° or 90° (an angle of 0° to 90°) with respect to the symmetry planes **325a** and **325c.** The polarization direction **324** of the nitride semiconductor light-emitting element **300** may be inclined by an angle of not less than 25° and not more than 65° with respect to the symmetry planes **325a** and **325c.** This inclination angle may be not less than 35° and not more than 55°. In the present embodiment, the incident light **330** that is incident on the interface **321** also includes an S-polarization component and a P-polarization component.

As seen from FIG. **9(b),** the incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325a** or the symmetry plane **325c.** More preferably, the nitride semiconductor light-emitting element **300** is placed such that at least part of the nitride semiconductor light-emitting element **300** is present on the intersecting line of the symmetry plane **325a** and the symmetry plane **325c.** Still more preferably, the nitride semiconductor light-emitting element **300** is placed such that the center of the nitride semiconductor light-emitting element **300** is present on the intersecting line of the symmetry plane **325a** and the symmetry plane **325c.**

Thus, placing the nitride semiconductor light-emitting element **300** on the symmetry plane also improves the symmetry of the light distribution pattern of light extracted from the transparent encapsulating member **320**.

(Embodiment 7)

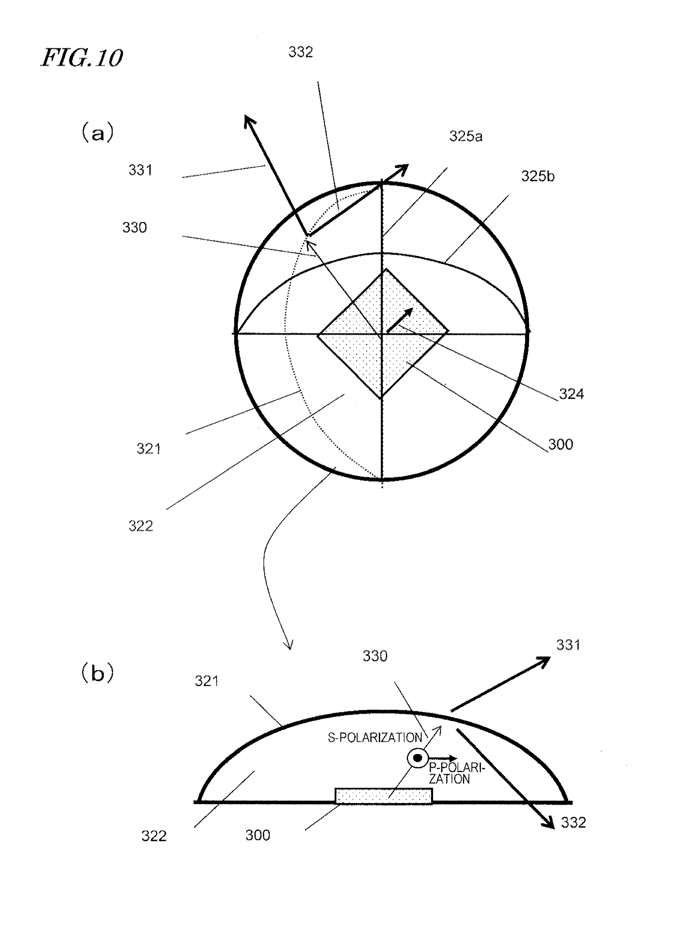

Next, the seventh embodiment of the nitride-based semiconductor light-emitting device of the present invention is described with reference to FIG. **10**.

In the present embodiment, the transparent encapsulating member **320** has an aspheric shape as shown in FIG. **10(a)** and FIG. **10(b).** The base surface of the transparent encapsulating member **320** (a surface of the transparent encapsulating member **320** on which the nitride semiconductor light-emitting element **300** is placed) has an elliptical shape. In this case, the transparent encapsulating member **320** has two symmetry planes, i.e., the symmetry planes **325a** and **325b.**

When the incidence plane **322** is considered, for example, the interface **321** in a cross section of the transparent encapsulating member **320** has a deformed spherical shape. It is important that the shape of the interface **321** is determined such that the incident light **330** from the nitride semiconductor light-emitting element **300** includes a component which is to be reflected by the interface **321**.

The polarization direction **324** of the nitride semiconductor light-emitting element **300** is inclined by an angle which does not include 0° or 90° (an angle of 0° to 90°) with respect to the symmetry planes **325a** and **325b**. The polarization direction **324** of the nitride semiconductor light-emitting element **300** may be inclined by an angle of not less than 25° and not more than 65° with respect to the symmetry planes **325a** and **325b**. This inclination angle may be not less than 35° and not more than 55°.

In the present embodiment, the incident light **330** that is incident on the interface **321** also includes an S-polarization component and a P-polarization component. The incident light **330** includes a component which is incident on the interface **321** at an angle equal to or greater than the critical angle, and therefore, the reflected light **332** of that component is circularly-polarized light or elliptically-polarized light, so that the polarization degree can be decreased.

The nitride semiconductor light-emitting element **300** is preferably placed such that at least part of the nitride semiconductor light-emitting element **300** is present on the symmetry plane **325a** or the symmetry plane **325b**. More preferably, the nitride semiconductor light-emitting element **300** is placed such that at least part of the nitride semiconductor light-emitting element **300** is present on the intersecting line of the symmetry plane **325a** and the symmetry plane **325b**. Still more preferably, the nitride semiconductor light-emitting element **300** is placed such that the center of the nitride semiconductor light-emitting element **300** is present on the intersecting line of the symmetry plane **325a** and the symmetry plane **325b**. Thus, placing the nitride semiconductor light-emitting element **300** on the symmetry plane also improves the symmetry of the light distribution pattern of light extracted from the transparent encapsulating member **320**.

(Embodiment 8)

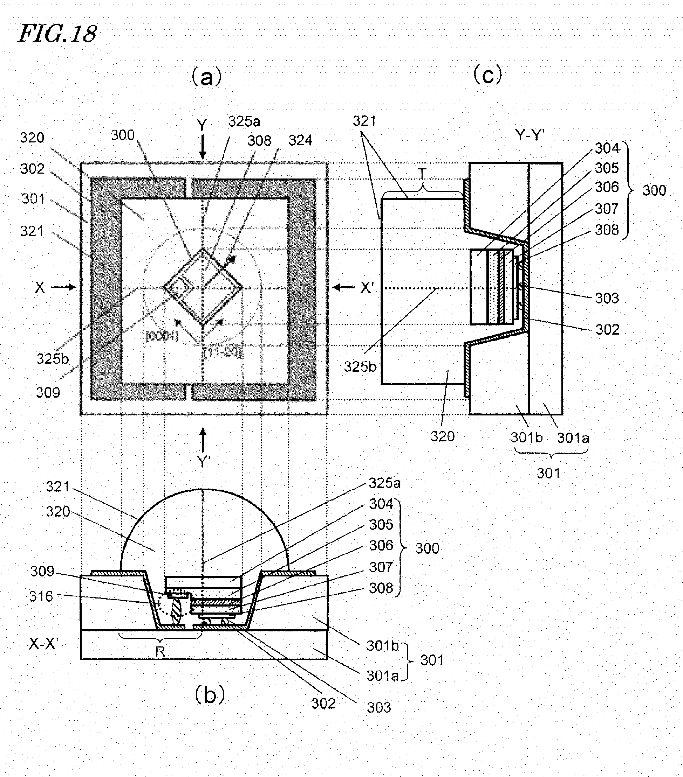

Next, the eighth embodiment of the nitride-based semiconductor light-emitting device of the present invention is described with reference to FIG. **18**.

FIG. **18** schematically shows a nitride semiconductor light-emitting device of the present embodiment. FIG. **18 (a)** is a top view. FIG. **18(b)** is a cross-sectional view taken along line **X-X'**. FIG. **18(c)** is a cross-sectional view taken along line **Y-Y'**.

The difference of the present embodiment from Embodiment 1 resides in that the mounting base **301** has a recessed portion.

The mounting base **301** includes a base **301a** and a reflector plate **301b** which is provided on the base **301a**. The reflector plate **301b** has a cavity at the center, which has a size capable of containing the nitride semiconductor light-emitting element **300**. The base **301a** and the reflector plate **301b** may be made of the same material or may be made of different materials. For example, the base **301a** may be made of alumina or AlN, while the reflector plate **301b** may be made of a resin which has a high reflectance. When the base **301a** and the reflector plate **301b** are made of the same material, e.g., alumina or AlN, the base **301a** and the reflector plate **301b** can be integrated by sintering or any other method. When the base **301a** and the reflector plate **301b** are made of a metal, press molding may be performed such that a recessed portion is formed in a central portion of the reflector plate **301b**. In this way, the base **301a** and the reflector plate **301b** may be realized by a single-piece part, although the base **301a** and the reflector plate **301b** are distinguishably shown in FIGS. **18(b)** and **18(c)**.

In the present embodiment, providing a recessed portion in the mounting base **301** enables control of the light distribution characteristics.

In the present embodiment, the transparent encapsulating member 320 is also placed so as to cover the entirety of the nitride semiconductor light-emitting element 300 that has the polarization characteristic. The transparent encapsulating member 320 is also provided in the recessed portion of the mounting base 301. The transparent encapsulating member 320 shown in FIG. 18 has a cylindrical shape. The polarization direction 324 of the nitride semiconductor light-emitting element 300 is inclined by an angle which does not include 0° or 90° (an angle of 0° to 90°) with respect to the symmetry planes **325a** and **325b**. The polarization direction **324** of the nitride semiconductor light-emitting element **300** may be inclined by an angle of not less than 25° and not more than 65° with respect to the symmetry planes **325a** and **325b**. This inclination angle may be not less than 35° and not more than 55°.

In the present embodiment, the distance from the cylindrical interface **321** to the nitride semiconductor light-emitting element **300** is long. That is, the length of the shortest part of the transparent encapsulating member **320** is different from that of Embodiment 1. The length of the shortest part of the transparent encapsulating member **320** only needs to be not less than the length of the longest part of the nitride semiconductor light-emitting element **300,** and therefore, the present embodiment more readily satisfies this condition than Embodiment 1. Here, the shortest part of the transparent encapsulating member **320** refers to the length of the shortest distance between the intersection of the diagonal lines of a quadrangle which is obtained by projecting orthogonally the shape of the nitride semiconductor light-emitting element **300** onto the mounting base **301** and the interface **321** between the transparent encapsulating member **320** and its outside. When the top view of the nitride semiconductor light-emitting element **300** has a square or rectangular shape, the length of the diagonal line of the square or rectangular shape is the longest part of the nitride semiconductor light-emitting element **300.**

(Embodiment 9)

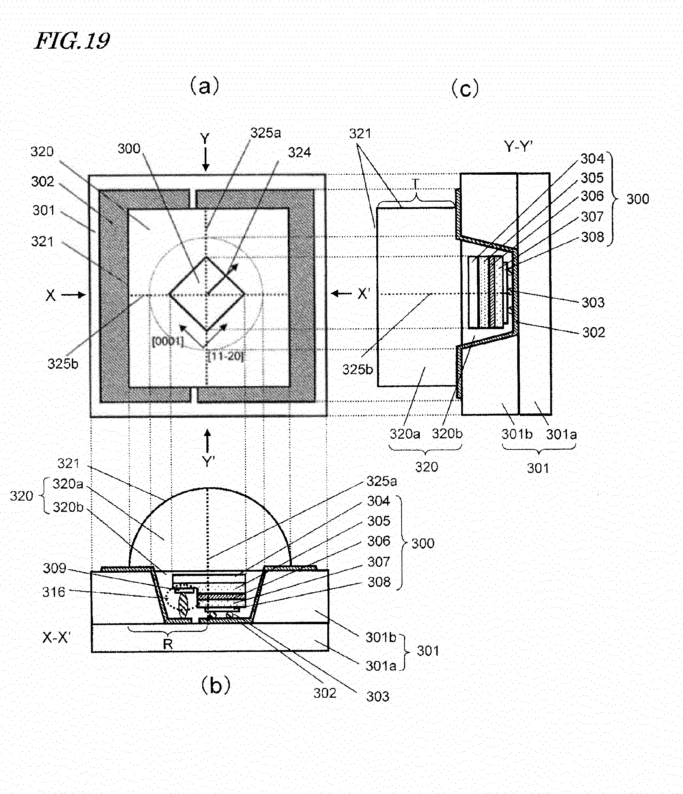

Next, the ninth embodiment of the nitride-based semiconductor light-emitting device of the present invention is described with reference to FIG. **19.**

FIG. **19** schematically shows a nitride semiconductor light-emitting device of an embodiment of the present invention. FIG. **19(a)** is a top view. FIG. **19(b)** is a cross-sectional view taken along line **X-X'.** FIG. **19(c)** is a cross-sectional view taken along line **Y-Y'.** The difference of the present embodiment from the embodiment of FIG. **18** resides in that the transparent encapsulating member **320** includes a transparent encapsulating member **320b** which is placed so as to cover the entirety of the nitride semiconductor light-emitting element **300** that has the polarization characteristic and a transparent encapsulating member **320a** which is provided outside the transparent encapsulating member **320b.** In the present embodiment, the interface **321** between the transparent encapsulating member **320** and its outside has a cylindrical shape as in the embodiment of FIG. **18.** When the single transparent encapsulating member **320** is thus constituted of a plurality of parts, the important part in the shape of the transparent encapsulating member **320** is its surface (interface **321).** Therefore, the symmetry plane of the transparent encapsulating member **320** is determined based on this interface **321.**

The polarization direction **324** of the nitride semiconductor light-emitting element **300** is inclined by an angle which does not include 0° or 90° (an angle of 0° to 90°) with respect to the symmetry planes **325a** and **325b.** The polarization direction **324** of the nitride semiconductor light-emitting element **300** may be inclined by an angle of not less than 25° and not more than 65° with respect to the symmetry plane **325a** and the symmetry plane **325b** of the transparent encapsulating member **320.** This inclination angle may be not less than 35° and not more than 55°.

In the present embodiment, different materials can be used for the transparent encapsulating members **320a** and **320b.** For example, a silicone resin or an epoxy resin can be used for the transparent encapsulating member **320b,** while an inorganic material such as, for example, glass, sapphire or ZnO can be used for the transparent encapsulating member **320a.** The silicone resin readily transmits gas and moisture. However, the exterior of the silicone resin part may be covered with an inorganic material to reduce transmission of gas or moisture. Thus, the reliability improves.

Materials which have different refractive indices may be used for the transparent encapsulating members **320a** and **320b.** For example, the refractive indices of a silicone resin and an epoxy resin which are used as the encapsulating material for LED are about 1.4 to 1.54, and therefore, the design flexibility of the transparent encapsulating member **320** is low. However, in the present embodiment, a high refraction material can be used for the transparent encapsulating member **320a.** For example, the refractive index of sapphire is about 1.75, the refractive index of ZnO is about 1.95, the refractive index of zirconium is about 2.4, the refractive index of titanium oxide is about 2.5, the refractive index of high refractive index plastic is about 1.74, and the refractive index of high refractive index glass is about 1.84, so that the design flexibility improves.

The effect of decreasing the polarization degree depends on the shape of the interface between the transparent encapsulating member **320a** and its outside, the angle formed between the symmetry plane of the transparent encapsulating member **320a** and the polarization direction **324** of the nitride semiconductor light-emitting element **300,** and the refractive index of the transparent encapsulating member **320a** shown in FIG. **16.** When the refractive index of the transparent encapsulating member **320a** is not less than 1.6, the polarization degree can be further decreased.

(Embodiment 10)

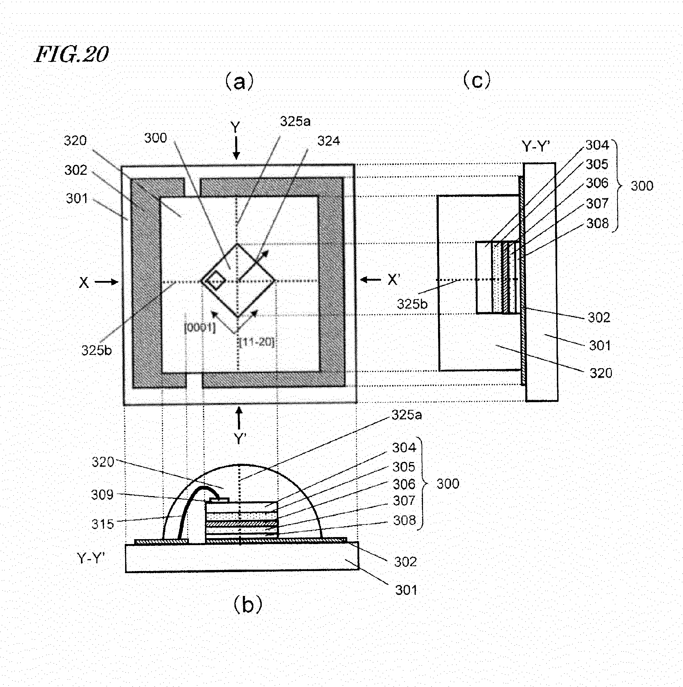

Next, the tenth embodiment of the nitride-based semiconductor light-emitting device of the present invention is described with reference to FIG. **20.**

FIG. **20** schematically shows a nitride semiconductor light-emitting device of the present embodiment. FIG. **20 (a)** is a top view. FIG. **20 (b)** is a cross-sectional view taken along line **X-X'.** FIG. **20(c)** is a cross-sectional view taken along line **Y-Y'.**

The difference of the present embodiment from Embodiment 1 resides in that the nitride semiconductor light-emitting element **300** is mounted to the wire **302** which is provided on the mounting base **301** via the p-side electrode **308,** and a wire **315** is provided so as to couple the n-side electrode **309** and the wire **302** together.

The transparent encapsulating member **320** is placed so as to cover the entirety of the nitride semiconductor light-emitting element **300** that has the polarization characteristic. The transparent encapsulating member **320** has a cylindrical shape. The polarization direction **324** of the nitride semiconductor light-emitting element **300** is inclined by an angle which does not include 0° or 90° (an angle of 0° to 90°) with respect to the symmetry planes **325a** and **325b.** The polarization direction **324** of the nitride semiconductor light-emitting element **300** may be inclined by an angle of not less than 25° and not more than 65° with respect to the symmetry planes **325a** and **325b.** This inclination angle may be not less than 35° and not more than 55°.

In the present embodiment, the area of junction of the p-side electrode **308** and the wire **302** can readily be increased, and therefore, the present embodiment has an advantage that the heat radiation characteristics can readily be improved.

(Embodiment 11)

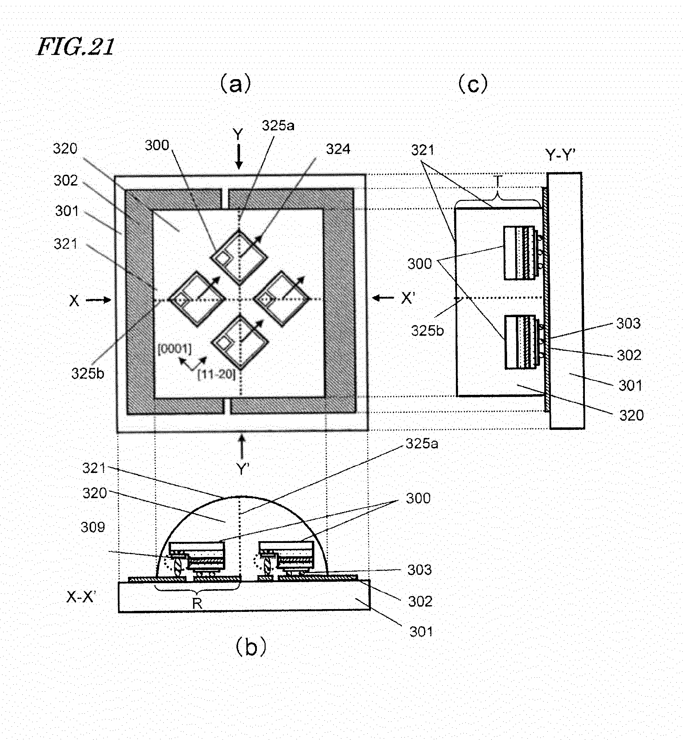

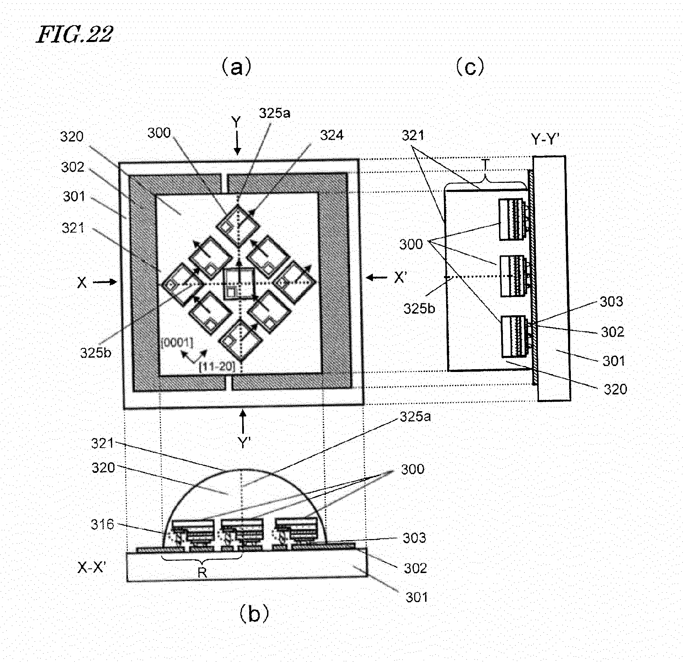

Next, the eleventh embodiment of the nitride-based semiconductor light-emitting device of the present invention is described with reference to FIGS. **21** and **22.**

The difference of the nitride-based semiconductor light-emitting device of the present embodiment from the nitride-based semiconductor light-emitting devices of the other embodiments resides in that one transparent encapsulating member **320** covers a plurality of nitride semiconductor light-emitting elements **300.**

The polarization direction of each of the nitride semiconductor light-emitting elements **300** is inclined by an angle which does not include 0° or 90° (45° in the examples shown in the drawings) with respect to the symmetry plane of the transparent encapsulating member **320.** Thus, even when a plurality of nitride semiconductor light-emitting elements **300** are covered with one transparent encapsulating member **320,** the polarization degree can be decreased based on the above-described principles.

In the example of FIG. **21,** four nitride semiconductor light-emitting elements **300** are covered with one transparent encapsulating member **320.** The number of nitride semiconductor light-emitting elements **300** which are covered with one transparent encapsulating member **320** is not limited to one or four but may be any other number.

FIG. **22** shows an example where nine nitride semiconductor light-emitting elements **300** are covered with one transparent encapsulating member **320.** In this example, the polarization direction of one of the nine nitride semiconductor light-emitting elements **300** which is positioned at the center of the nine nitride semiconductor light-emitting elements **300** forms an angle of 0° or 90° with respect to the symmetry planes of the transparent encapsulating member **320.** The polarization directions of the other eight nitride semiconductor light-emitting elements **300** are inclined by an angle which does not include 0° or 90° (45° in the example shown in the drawing) with respect to the symmetry planes of the transparent encapsulating member **320.** When a plurality of nitride semiconductor light-emitting elements **300** are thus covered with one transparent encapsulating member **320,** the polarization directions of all the nitride semiconductor light-emitting elements **300** do not need to be inclined by an angle which does not include 0° or 90° (45° in the example shown in the drawing) with respect to the symmetry planes of the transparent encapsulating member **320.** Also, as shown in the example of FIG. **22,** the angles formed by the polarization directions of the nitride semiconductor light-emitting elements **300** with respect to the symmetry planes of the transparent encapsulating member **320** do not need to be equal among all the nitride semiconductor light-emitting elements **300.**

(Embodiment 12)

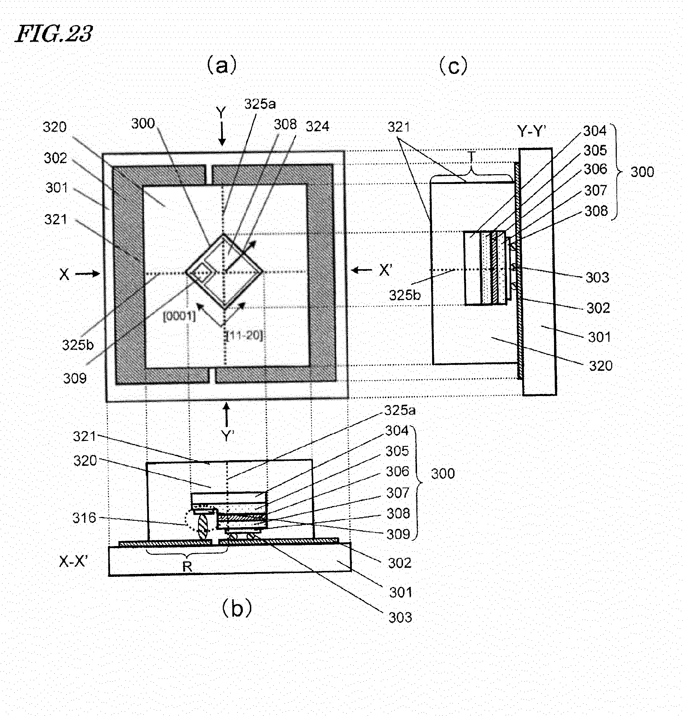

Next, the twelfth embodiment of the nitride-based semiconductor light-emitting device of the present invention is described with reference to FIG. **23.**

The difference of the nitride-based semiconductor light-emitting device of the present embodiment from the nitride-based semiconductor light-emitting devices of the other embodiments resides in that the shape of the transparent encapsulating member **320** is a rectangular parallelpiped.

The polarization direction **324** of the nitride semiconductor light-emitting element **300** is inclined by an angle which does not include 0° or 90° (45° in the example shown in the drawing) with respect to the symmetry planes of the transparent encapsulating member **320.** Thus, even when the shape of the transparent encapsulating member **320** is a rectangular parallelpiped, the polarization degree can be decreased. The angle formed by the polarization direction **324** with respect to the symmetry planes **325a** and **325b** is preferably 35° to 55° and more preferably 37° to 53°.

The transparent encapsulating members **320** shown in FIG. **18** to FIG. **22** (Embodiments 8 to 11) have the cylindrical shape shown in FIG. **4.** However, the shape of these transparent encapsulating members **320** is not limited to the cylindrical shape. In Embodiments 8 to 11, the same effects can be achieved even when the transparent encapsulating member **320** has any of the shapes shown in FIG. **5** to FIG. **10** and FIG. **23.**

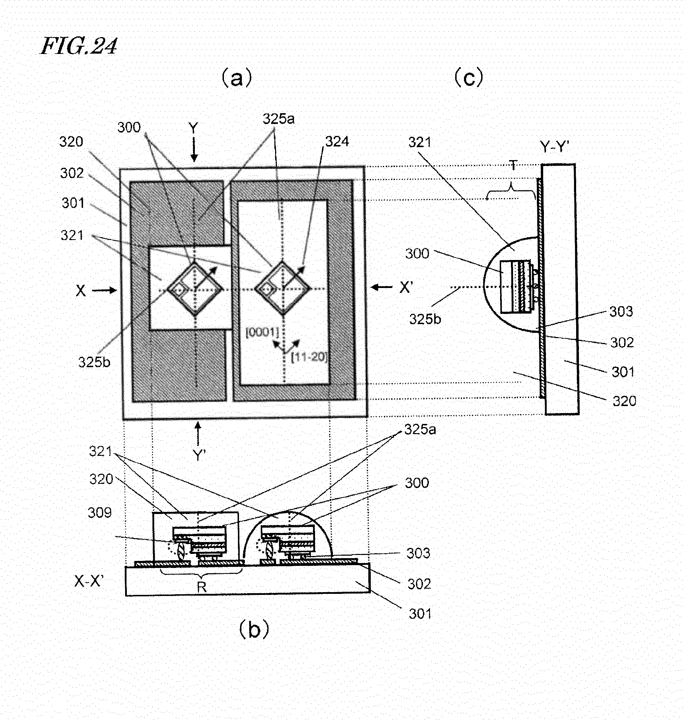

In each of the above-described embodiments, one transparent encapsulating member **320** is provided on one mounting base, although a plurality of transparent encapsulating members **320** may be provided on one mounting base as shown in FIG. **24.** In the example shown in FIG. **24,** the polarization direction of at least one nitride semiconductor light-emitting element **300** which is covered with respective one of the transparent encapsulating members **320** is inclined by an angle which does not include 0° or 90° with respect to the symmetry planes of the transparent encapsulating member **320.** In this case, the transparent encapsulating members **320** which are provided on one mounting base may have different shapes, different sizes, and different orientations.

Hereinafter, examples of the present invention are described.

(Example 1)

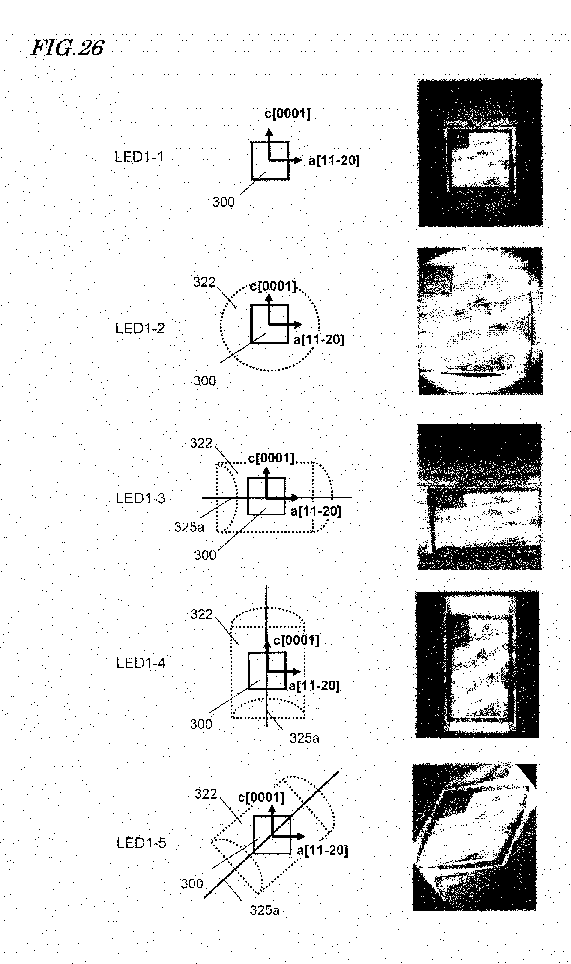

A nitride-based semiconductor light-emitting element was formed on an *m*-plane n-type GaN substrate. The nitride-based semiconductor light-emitting element included an n-type nitride semiconductor layer formed of a n-type GaN layer having a thickness of 2 $\mu$m, a nitride semiconductor active layer which had a quantum well structure consisting of three cycles of InGaN quantum well layers each having a thickness of 15 nm and GaN barrier layers each having a thickness of 30 nm, and a p-type nitride semiconductor layer formed of a p-type GaN layer having a thickness of 0.5 $\mu$m. Ti/Pt layers were formed as the n-side electrode, and Pd/Pt layers were formed as the p-side electrode. The thickness of the *m*-plane n-type GaN substrate was as thin as 150 $\mu$m. The nitride-based semiconductor light-emitting element was diced along the c-axis direction [0001] and the *a*-axis direction [11-20] into 800 $\mu$m-square small pieces. The diced nitride-based semiconductor light-emitting element (LED) was mounted on an alumina mounting base using an Au bump. In operation at 10 mA, the peak emission wavelength of the LED was 437 nm. A transparent encapsulating member which was made of sapphire in the shape of a hemisphere having the diameter of 2.2 mm, and a cylindrical transparent encapsulating member which was made of sapphire, with a 2.2 mm-square base surface, height T of 1.1 mm, and radius R of 1.1 mm, were separately prepared. These transparent encapsulating members were directly placed over the LED. FIG. **26** shows the relationship between the shape of the transparent encapsulating member and the orientation of the LED, and the top-view optical microscopic images.

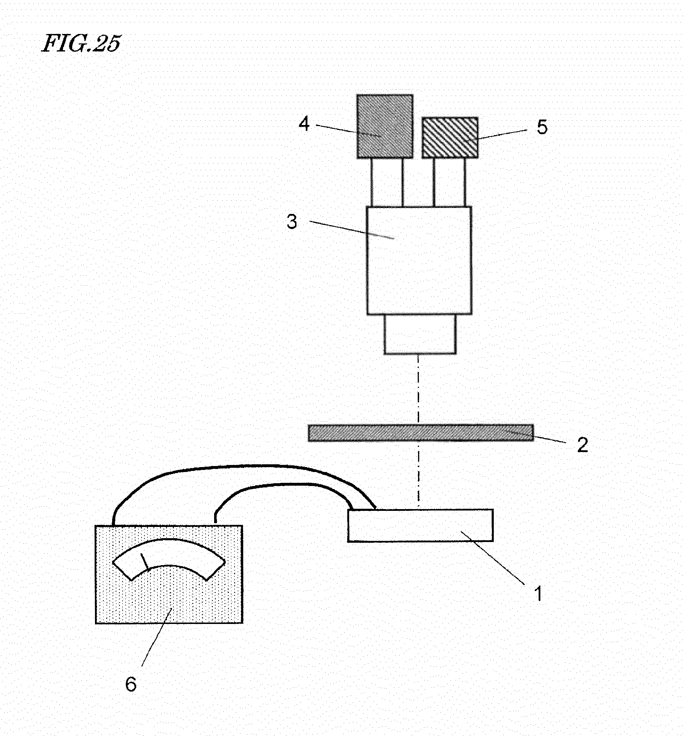

A method for measuring the polarization degree is described with reference to FIG. **25.**

First, a silicon photodetector **4** was attached to one of the ports of a stereoscopic microscope **3** manufactured by OLYMPUS Corporation. The silicon photodetector **4** was controlled by SC6000 manufactured by Labsphere, Inc. A CCD camera **5** was attached to the other port of the stereoscopic microscope **3** for checking the state of emission. A LED **1** was driven with a small electric current of 5 mA using a power supply **6** manufactured by ADVANTEST Corporation. Note that, in FIG. **25,** the LED **1** is illustrated in a simplified form, and illustration of the resin encapsulating member and other elements is omitted.

Between the stereoscopic microscope **3** and the LED **1,** a polarizing plate **2** was inserted so as to be parallel to the LED **1.** The optical output (power) was monitored by the silicon photodetector **4,** while the polarizing plate **2** was rotated, whereby the minimum *Imin* and the maximum *Imax* of the optical output were determined. From the minimum *Imin* and the maximum *Imax,* the polarization degree was calculated according to the formula of |Imax-Imin|/|Imax+Imin|.

When no transparent encapsulating member is provided over the LED (LED **1-1),** the polarization degree of the LED **1-1** during operation at 5 mA was 0.70.

A hemispherical transparent encapsulating member was provided over the LED (LED **1-2).** In this case, the polarization degree of the LED **1-2** during operation at 5 mA was 0.70. This means that the polarization degree which was achieved with no transparent encapsulating member was maintained.

A cylindrical transparent encapsulating member was provided over the LED such that the angle formed between the symmetry plane **325a** and the *a*-axis of the LED (polarization direction) was 0° (LED **1-3).** In this case, the polarization degree of the LED **1-3** during operation at 5 mA was 0.75. This value was close to the polarization degree which was achieved with no transparent encapsulating member.

A cylindrical transparent encapsulating member was provided over the LED such that the angle formed between the symmetry plane **325a** and the *a*-axis of the LED (polarization direction) was 90° (LED **1-4**). In this case, the polarization degree of the LED **1-4** during operation at 5 mA was 0.60. This value was close to the polarization degree which was achieved with no transparent encapsulating member.

A cylindrical transparent encapsulating member was provided over the LED such that the angle formed between the symmetry plane **325a** and the *a*-axis of the LED (polarization direction) was 45°, whereby the embodiment of FIG. **3** was manufactured (LED **1-5).** In this case, the polarization degree of the LED **1-5** during operation at 5 mA was 0.10. This value was considerably small as compared with the polarization degree which was achieved with no transparent encapsulating member.

As seen from the experimental results, when the shape of the transparent encapsulating member was a hemispherical shape which is commonly employed, the polarization degree was maintained. When the angle formed between the symmetry plane **325a** of the cylindrical transparent encapsulating member and the *a*-axis of the LED (polarization direction) was 0° or 90°, the polarization degree was maintained. When the angle formed between the symmetry plane **325a** of the cylindrical transparent encapsulating member and the *a*-axis of the LED (polarization direction) was 45°, the polarization degree decreased.

It is understood from the above that, by appropriately selecting the shape of the transparent encapsulating member and the polarization direction of the nitride-based semiconductor light-emitting element with respect to the symmetry plane of the transparent encapsulating member, decrease of the polarization degree can be realized.

(Example 2)

A nitride-based semiconductor light-emitting element was formed on an *m*-plane n-type GaN substrate. The nitride-based semiconductor light-emitting element included an n-type nitride semiconductor layer formed of a n-type GaN layer having a thickness of 2 $\mu$m, a nitride semiconductor active layer which had a quantum well structure consisting of three cycles of InGaN quantum well layers each having a thickness of 15 nm and GaN barrier layers each having a thickness of 30 nm, and a p-type nitride semiconductor layer formed of a p-type GaN layer having a thickness of 0.5 $\mu$m. Ti/Pt layers were formed as the n-side electrode, and Pd/Pt layers were formed as the p-side electrode. The nitride-based semiconductor light-emitting element was diced along the *c*-axis direction [0001] and the *a*-axis direction [11-20] into 300 $\mu$m-square small pieces. The diced nitride-based semiconductor light-emitting element (LED) was mounted on an alumina mounting base which had a recessed portion in the surface, using an Au bump. In operation at 10 mA, the peak emission wavelength of the LED was 457 nm. The LED had a configuration which could be contained in the recessed portion of the mounting base. A silicone resin whose refractive index was 1.42 was injected into the recessed portion. On the resultant structure, a transparent encapsulating member which was made of sapphire in the shape of a hemisphere with the diameter of 2.2 mm, and a cylindrical transparent encapsulating member which was made of sapphire with a 2.2 mm-square base surface, height *T* of 1.1 mm, and radius *R* of 1.1 mm were placed, whereby the embodiment of FIG. **19** was manufactured. A material which had a low viscosity was used as the silicone resin such that the transparent encapsulating member which had a cylindrical shape was rotatable.

The polarization degree of the LED was measured, while the cylindrical transparent encapsulating member was rotated such that the angle formed between the symmetry plane **325a** of the cylindrical shape and the *a*-axis of the LED (polarization direction) had varying angles.

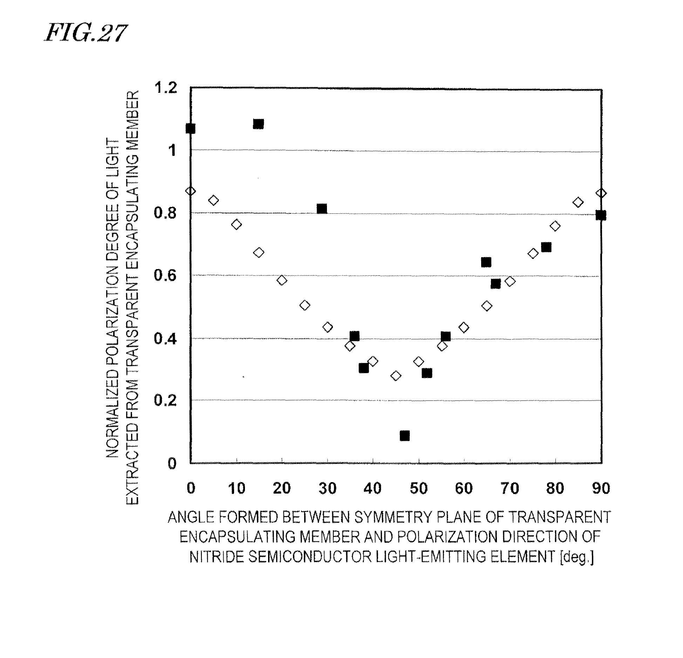

FIG. **27** shows the relationship between the normalized polarization degree of light extracted from the transparent encapsulating member and the angle formed between the symmetry plane **325a** of the transparent encapsulating member and the polarization direction of the nitride-based semiconductor light-emitting element (*a*-axis direction). In FIG. **27,** solid boxes ■ represent the measured values. Here, the measured values refer to values normalized with the polarization degree obtained before formation of the transparent encapsulating member, which was used as the reference value. Open diamonds ◊ represent the calculated values shown in FIG. **17,** which are shown again in this graph. It is seen that the actual measurement results and the calculation results are in good accordance with each other.

As seen from FIG. **27,** the normalized polarization degree is the smallest, when the angle formed between the symmetry plane **325a** of the transparent encapsulating member and the polarization direction of the nitride-based semiconductor light-emitting element (*a*-axis direction) is about 45°.

When the polarization direction of the nitride semiconductor light-emitting element is in the range of 37° to 53° with respect to the symmetry planes **325a** and **325b,** the normalized polarization degree can be decreased to about 0.3. When the polarization direction of the nitride semiconductor light-emitting element is in the range of 35° to 55° with respect to the symmetry planes **325a** and **325b,** the normalized polarization degree can be decreased to about 0.4.

(Example 3)

A nitride-based semiconductor light-emitting element was formed on an *m*-plane n-type GaN substrate. The nitride-based semiconductor light-emitting element included an n-type nitride semiconductor layer formed of a n-type GaN layer having a thickness of 2 $\mu$m, a nitride semiconductor active layer which had a quantum well structure consisting of three cycles of InGaN quantum well layers each having a thickness of 15 nm and GaN barrier layers each having a thickness of 30 nm, and a p-type nitride semiconductor layer formed of a p-type GaN layer having a thickness of 0.5 $\mu$m.

Ti/Pt layers were formed as the n-side electrode, and Pd/Pt layers were formed as the p-side electrode. The nitride-based semiconductor light-emitting element was diced along the c-axis direction [0001] and the *a*-axis direction [11-20] into 300 $\mu$m-square small pieces. The diced nitride-based semiconductor light-emitting element (LED) was mounted on an alumina mounting base using an Au bump. In operation at 10 mA, the peak emission wavelength of the LED was 456 nm. Further, a cylindrical transparent encapsulating member which was made of sapphire was separately prepared.

Before placement of the transparent encapsulating member, the polarization degree of the 300 $\mu$m-square LED was 0.61 during operation at 5 mA.

On the LED, a cylindrical transparent encapsulating member with height *T* of 1.1 mm, radius *R* of 1.1 mm, and a 2.2 mm-square base surface was placed such that the angle formed between the symmetry plane **325a** of the cylindrical shape and the *a*-axis of the LED (polarization direction) was 0°, 45°, and 90°.

On the LED, a cylindrical transparent encapsulating member with height *T* of 0.8 mm and radius *R* of 1.1 mm was placed such that the angle formed between the symmetry plane **325a** of the cylindrical shape and the *a*-axis of the LED (polarization direction) was 0°, 45°, and 90°.

On the LED, a cylindrical transparent encapsulating member with height *T* of 0.5 mm and radius *R* of 1.1 mm was placed such that the angle formed between the symmetry plane **325a** of the cylindrical shape and the *a*-axis of the LED (polarization direction) was 0°, 45°, and 90°.

Table 1 shows the polarization degree during operation of the manufactured LEDs at 5 mA. With either of the cylindrical lens shapes, the polarization degree was the smallest when the angle formed between the symmetry plane **325a** of the cylindrical shape and the *a*-axis of the LED (polarization direction) was 45°. It was also found that, as the ratio of the longest part of the nitride-based semiconductor light-emitting element to the shortest part of the transparent encapsulating member decreases, the effect of decreasing the polarization degree decreases.

As seen from the above results, the polarization degree can be decreased even when the height of the cylindrical shape is smaller than the radius of the cylindrical shape.

The lens shape which is obtained when the height of the cylindrical shape is smaller than the radius of the cylindrical shape corresponds to the embodiment shown in FIG. **5**. Further, Embodiment 2 of FIG. **5** is similar in shape to Embodiment 7 of FIG. **10,** and therefore, it is inferred that the same effects are also achieved in Embodiment 7 of FIG. **10.**

[Table 1]

| Size of Nitride-based Semiconductor Light-remitting Element [μm-square] | Shape of Cylindrical Lens | | Ratio of Longest Part of Nitride-based Semiconductor Light-emitting Element to Shortest Part of Transparent Encapsulating member | Without Transparent Encapsulating member | Angle Between Symmetry Plane of Transparent Encapsulating member and Polarization Direction | | |
|---|---|---|---|---|---|---|---|
| | T [mm] | R [mm] | | | 0 deg. | 90 deg. | 45 deg. |
| 300 | 1.1 | 1.1 | 2.60 | 0.61 | 0.77 | 0.62 | 0.15 |
| 300 | 0.8 | 1.1 | 1.89 | 0.61 | 0.77 | 0.62 | 0.46 |
| 300 | 0.5 | 1.1 | 1.18 | 0.61 | 0.45 | 0.57 | 0.40 |

(Example 4)

A nitride-based semiconductor light-emitting element was formed on an *m*-plane n-type GaN substrate. The nitride-based semiconductor light-emitting element included an n-type nitride semiconductor layer formed of a n-type GaN layer having a thickness of 2 μm, a nitride semiconductor active layer which had a quantum well structure consisting of three cycles of InGaN quantum well layers each having a thickness of 15 nm and GaN barrier layers each having a thickness of 30 nm, and a p-type nitride semiconductor layer formed of a p-type GaN layer having a thickness of 0.5 μm.

Ti/Pt layers were formed as the n-side electrode, and Pd/Pt layers were formed as the p-side electrode. The nitride-based semiconductor light-emitting element was diced along the *c*-axis direction [0001] and the *a*-axis direction [11-20] into 300 μm-square small pieces and 800 μm-square small pieces. The diced nitride-based semiconductor light-emitting element (LED) was mounted on an alumina mounting base using an Au bump. Further, a cylindrical transparent encapsulating member which was made of sapphire was separately prepared and directly placed on the LED.

Before placement of the transparent encapsulating member, the polarization degree of the 800 μm-square LED was 0.70 during operation at 5 mA. The polarization degree of the 300 μm-square LED was 0.61 during operation at 5 mA.

On the 800 μm-square LED, a cylindrical transparent encapsulating member with height *T* of 1.1 mm, radius *R* of 1.1 mm, and a 2.2 mm-square base surface was placed such that the angle formed between the symmetry plane **325a** of the cylindrical shape and the *a*-axis of the LED (polarization direction) was 0°, 45°, and 90°.

On the 800 μm-square LED, a cylindrical transparent encapsulating member with height *T* of 2.0 mm, radius *R* of 2.0 mm, and a 4.0 mm-square base surface was placed such that the angle formed between the symmetry plane **325a** of the cylindrical shape and the *a*-axis of the LED (polarization direction) was 0°, 45°, and 90°.

On the 300 μm-square LED, a cylindrical transparent encapsulating member with height *T* of 1.1 mm, radius *R* of 1.1 mm, and a 2.2 mm-square base surface was placed such that the angle formed between the symmetry plane **325a** of the cylindrical shape and the *a*-axis of the LED (polarization direction) was 0°, 45°, and 90°.

Table 2 shows the polarization degree during operation of the manufactured LEDs at 5 mA. With either of the cylindrical lens shapes, the polarization degree was the smallest when the angle formed between the symmetry plane **325a** of the cylindrical shape and the *a*-axis of the LED (polarization direction) was 45°.

In either case, the original polarization degree was maintained when the angle formed between the symmetry plane **325a** of the cylindrical shape and the *a*-axis of the LED (polarization direction) was 0° or 90°. On the other hand, the polarization degree decreased when the angle formed between the symmetry plane **325a** of the cylindrical shape and the *a*-axis of the LED (polarization direction) was 45°.

It is appreciated from the above results that, preferably, the length of the shortest part of the transparent encapsulating member is generally equal to or greater than the longest part of the nitride-based semiconductor light-emitting element.

[Table 2]

| Size of Nitride-based Semiconduc tor Light-emitting Element [μm-square] | Shape of Cylindrical Lens | | Ratio of Longest Part of Nitride-based Semiconductor Light-emitting Element to Shortest Part of Transparent Encapsulating member | Without Transpar ent Encapsul ating member | Angle Between Symmetry Plane of Transparent Encapsulating member and Polarization Direction | | |
|---|---|---|---|---|---|---|---|
| | T [mm] | R [mm] | | | 0 deg. | 90 deg. | 45 deg. |
| 800 | 1.1 | 1.1 | 0.98 | 0.70 | 0.60 | 0.75 | 0.10 |
| 800 | 2 | 2 | 1.77 | 0.70 | 0.70 | 0.65 | 0.07 |
| 300 | 1.1 | 1.1 | 2.60 | 0.61 | 0.77 | 0.62 | 0.15 |

## INDUSTRIAL APPLICABILITY

According to the present invention, the polarization degree of a nitride-based semiconductor light-emitting element which is formed on a non-polar or semi-polar plane can be decreased. Since the amount of reflection of light would not vary depending on the installation orientation of the nitride-based semiconductor light-emitting element, the nitride-based semiconductor light-emitting element is suitable for decorative illumination and lighting purposes.

## REFERENCE SIGNS LIST

| | |
|---|---|
| **1** | LED |
| **2** | polarizing plate |
| **3** | stereoscopic microscope |
| **4** | silicon photodetector |
| **5** | CCD camera |
| **6** | power supply |
| **300** | nitride-based semiconductor light-emitting element |
| **301** | mounting base |
| **301a** | base |
| **301b** | reflector plate |
| **302** | wire |
| **303** | bump |
| **304** | substrate |
| **305** | n-type nitride semiconductor layer |
| **306** | nitride semiconductor active layer |
| **307** | p-type nitride semiconductor layer |
| **308** | p-side electrode |

(continued)

| 309 | n-side electrode |
| 315 | wire |
| 316 | recessed portion |
| 320 | transparent encapsulating member |
| 321 | interface |
| 322 | incidence plane |
| 324 | polarization direction |
| 325 | symmetry plane |
| 330 | incident light |
| 331 | transmitted light |
| 332 | reflected light |
| 333 | incidence angle |

**Claims**

1. A nitride semiconductor light-emitting device, comprising:

   a nitride semiconductor light-emitting element which is configured to emit from an active layer polarized light which is polarized in a polarization direction which is included in a plane parallel to the active layer; and
   a transparent encapsulating member covering the nitride semiconductor light-emitting element, the transparent encapsulating member having a symmetry plane which is perpendicular to the active layer,
   wherein the polarization direction of the nitride semiconductor light-emitting element is inclined by an angle which does not include 0° or 90° with respect to the symmetry plane of the transparent encapsulating member.

2. The nitride semiconductor light-emitting device of claim 1, wherein the polarization direction of the nitride semiconductor light-emitting element is inclined by an angle of not less than 25° and not more than 65° with respect to the symmetry plane of the transparent encapsulating member.

3. The nitride semiconductor light-emitting device of claim 1, wherein the polarization direction of the nitride semiconductor light-emitting element is inclined by an angle of not less than 35° and not more than 55° with respect to the symmetry plane of the transparent encapsulating member.

4. The nitride semiconductor light-emitting device of any of claims 1 to 3, wherein the transparent encapsulating member has a shape which constitutes part of a semicylinder.

5. The nitride semiconductor light-emitting device of any of claims 1 to 3, wherein the transparent encapsulating member has a shape which constitutes part of a circular cone.

6. The nitride semiconductor light-emitting device of any of claims 1 to 3, wherein the transparent encapsulating member has a shape which constitutes part of a polygonal prism.

7. The nitride semiconductor light-emitting device of any of claims 1 to 3, wherein the transparent encapsulating member has a shape which constitutes part of a polygonal cone.

8. The nitride semiconductor light-emitting device of any of claims 1 to 3, wherein the transparent encapsulating member has a shape which constitutes part of an elliptical sphere.

9. The nitride semiconductor light-emitting device of any of claims 1 to 3, wherein the transparent encapsulating member has a shape which constitutes part of a rectangular parallelpiped.

10. The nitride semiconductor light-emitting device of any of claims 1 to 8, further comprising a mounting base which supports the nitride semiconductor light-emitting element.

11. A nitride semiconductor light-emitting device, comprising:

a first nitride semiconductor light-emitting element which includes a first active layer, the first nitride semiconductor light-emitting element being configured to emit from the first active layer polarized light which is polarized in a first polarization direction which is included in a plane parallel to the first active layer;

a second nitride semiconductor light-emitting element which includes a second active layer, the second nitride semiconductor light-emitting element being configured to emit from the second active layer polarized light which is polarized in a second polarization direction which is included in a plane parallel to the second active layer; and

a transparent encapsulating member covering the first nitride semiconductor light-emitting element and the second nitride semiconductor light-emitting element, the transparent encapsulating member having a symmetry plane which is perpendicular to the first and second active layers,

wherein each of the first polarization direction of the first nitride semiconductor light-emitting element and the second polarization direction of the second nitride semiconductor light-emitting element is inclined by an angle which does not include 0° or 90° with respect to the symmetry plane of the transparent encapsulating member.

12. The nitride semiconductor light-emitting device of claim 11, wherein the first polarization direction and the second polarization direction are parallel to each other.

13. The nitride semiconductor light-emitting device of claim 11, wherein the first polarization direction and the second polarization direction are not parallel to each other.

14. The nitride semiconductor light-emitting device of any of claims 11 to 13, wherein at least one of the first polarization direction and the second polarization direction is inclined by an angle of not less than 25° and not more than 65° with respect to the symmetry plane of the transparent encapsulating member.

15. The nitride semiconductor light-emitting device of claims 11 to 14, wherein the polarization direction of the nitride semiconductor light-emitting element is inclined by an angle of not less than 35° and not more than 55° with respect to the symmetry plane of the transparent encapsulating member.

16. The nitride semiconductor light-emitting device of any of claims 11 to 15, wherein the transparent encapsulating member has a shape which constitutes part of a semicylinder.

17. The nitride semiconductor light-emitting device of any of claims 11 to 15, wherein the transparent encapsulating member has a shape which constitutes part of a circular cone.

18. The nitride semiconductor light-emitting device of any of claims 11 to 15, wherein the transparent encapsulating member has a shape which constitutes part of a polygonal prism.

19. The nitride semiconductor light-emitting device of any of claims 11 to 15, wherein the transparent encapsulating member has a shape which constitutes part of a polygonal cone.

20. The nitride semiconductor light-emitting device of any of claims 11 to 15, wherein the transparent encapsulating member has a shape which constitutes part of an elliptical sphere.

21. The nitride semiconductor light-emitting device of any of claims 11 to 15, wherein the transparent encapsulating member has a shape which constitutes part of a rectangular parallelpiped.

22. The nitride semiconductor light-emitting device of any of claims 11 to 15, further comprising a mounting base which supports the first and second nitride semiconductor light-emitting elements.

23. A nitride semiconductor light-emitting device, comprising:

a first nitride semiconductor light-emitting element which includes a first active layer, the first nitride semiconductor light-emitting element being configured to emit from the first active layer polarized light which is polarized in a first polarization direction which is included in a plane parallel to the first active layer;

a second nitride semiconductor light-emitting element which includes a second active layer, the second nitride semiconductor light-emitting element being configured to emit from the second active layer polarized light which is polarized in a second polarization direction which is included in a plane parallel to the second active layer;

a first transparent encapsulating member covering the first nitride semiconductor light-emitting element, the first transparent encapsulating member having a symmetry plane which is perpendicular to the first active layer; and

a second transparent encapsulating member covering the second nitride semiconductor light-emitting element, the second transparent encapsulating member having a symmetry plane which is perpendicular to the second active layer,

wherein the first polarization direction of the first nitride semiconductor light-emitting element is inclined by an angle which does not include 0° or 90° with respect to the symmetry plane of the first transparent encapsulating member, and

the second polarization direction of the second nitride semiconductor light-emitting element is inclined by an angle which does not include 0° or 90° with respect to the symmetry plane of the second transparent encapsulating member.

24. The nitride semiconductor light-emitting device of claim 23, wherein the first polarization direction and the second polarization direction are parallel to each other.

25. The nitride semiconductor light-emitting device of claim 23, wherein the first polarization direction and the second polarization direction are not parallel to each other.

26. The nitride semiconductor light-emitting device of any of claims 23 to 25, wherein
the first polarization direction is inclined by an angle of not less than 25° and not more than 65° with respect to the symmetry plane of the first transparent encapsulating member, and
the second polarization direction is inclined by an angle of not less than 25° and not more than 65° with respect to the symmetry plane of the second transparent encapsulating member.

27. The nitride semiconductor light-emitting device of any of claims 23 to 25, wherein
the first polarization direction is inclined by an angle of not less than 35° and not more than 55° with respect to the symmetry plane of the first transparent encapsulating member, and
the second polarization direction is inclined by an angle of not less than 35° and not more than 55° with respect to the symmetry plane of the second transparent encapsulating member.

28. The nitride semiconductor light-emitting device of any of claims 23 to 27, wherein at least one of the first transparent encapsulating member and the second transparent encapsulating member has a shape which constitutes part of a semicylinder.

29. The nitride semiconductor light-emitting device of any of claims 23 to 27, wherein at least one of the first transparent encapsulating member and the second transparent encapsulating member has a shape which constitutes part of a circular cone.

30. The nitride semiconductor light-emitting device of any of claims 23 to 27, wherein at least one of the first transparent encapsulating member and the second transparent encapsulating member has a shape which constitutes part of a polygonal, prism.

31. The nitride semiconductor light-emitting device of any of claims 23 to 27, wherein at least one of the first transparent encapsulating member and the second transparent encapsulating member has a shape which constitutes part of a polygonal cone.

32. The nitride semiconductor light-emitting device of any of claims 23 to 27, wherein at least one of the first transparent encapsulating member and the second transparent encapsulating member has a shape which constitutes part of an elliptical sphere.

33. The nitride semiconductor light-emitting device of any of claims 23 to 27, wherein at least one of the first transparent encapsulating member and the second transparent encapsulating member has a shape which constitutes part of a rectangular parallelpiped.

34. The nitride semiconductor light-emitting device of any of claims 23 to 33, further comprising a mounting base which supports the first and second nitride semiconductor light-emitting elements.

*FIG.1A*

c-PLANE (0001)

a-PLANE (11-20)

m-PLANE (1-100)

*FIG.1B*

r-PLANE (1-102)

*FIG.1C*

(11-22) PLANE

*FIG.2*

(a)

● N

◍ Ga

(b)

◍ N

◍ Ga

[1-100]

[11-20]      [000-1]

*m*-PLANE

(c)

◍ N

◍ Ga

[0001]

[1-100]      [-1-120]

*c*-PLANE

FIG.3

(a)

(c)

(b)

*FIG.4*

TRANSMITTED
LIGHT 331

P-POLARIZATION
COMPONENT

REFLECTED LIGHT 332
(ONCE-REFLECTED)

S-POLARIZATION
COMPONENT

325a

325b

320

300

324

321

330

322

T

R

(a)

321

INCIDENCE ANGLE $\theta$ i 333

TRANSMITTED
LIGHT 331

LINEAR
POLARIZATION

GOOS=HANCHEN SHIFT

INCIDENT LIGHT 330

S-POLARIZATION
COMPONENT

P-POLARIZATION
COMPONENT

$\theta$

ELLIPTICAL
POLARIZATION

REFLECTED LIGHT 332
(ONCE-REFLECTED)

322

300

(b)

*FIG.5*

(a)

(b)

S-POLARIZATION

P-POLARI-ZATION

*FIG.6*

(a)

(b)

S-POLARIZATION

P-POLARI-
ZATION

*FIG.7*

(a)

(b)

*FIG.8*

(a)

(b)

S-POLARIZATION

P-POLARI-
ZATION

*FIG.9*

(a)

331
330
325c

332   325a   300

321   324
320

322   325d   325e

(b)

321   330   331

S-POLARIZATION
P-POLARI-
ZATION

332

322   300

*FIG.10*

(a)

(b)

S-POLARIZATION

P-POLARI-ZATION

*FIG.11*

P-POLARIZATION
S-POLARIZATION
CRITICAL ANGLE

TRANSMISSION INTENSITY

INCIDENCE ANGLE TO INTERFACE OF
TRANSPARENT ENCAPSULATING MEMBER $\theta i$ [deg]

*FIG.12*

AMOUNT OF VARIATION OF
POLARIZATION DIRECTION [deg]

INCIDENCE ANGLE TO INTERFACE OF TRANSPARENT
ENCAPSULATING MEMBER $\theta i$ [deg]

*FIG.13*

*FIG.14*

*FIG.15*

*FIG.16*

FIG.17

NORMALIZED POLARIZATION DEGREE OF LIGHT EXTRACTED FROM TRANSPARENT ENCAPSULATING MEMBER

ANGLE FORMED BETWEEN SYMMETRY PLANE OF TRANSPARENT ENCAPSULATING MEMBER AND POLARIZATION DIRECTION OF NITRIDE SEMICONDUCTOR LIGHT-EMITTING ELEMENT [deg.]

FIG.18

(a)

(b)

(c)

*FIG.19*

(a)

(c)

(b)

*FIG.20*

(a)                    (c)

(b)

*FIG.21*

(a)          (c)

(b)

*FIG.22*

(a)                    (c)

(b)

*FIG.23*

(a)

(c)

(b)

FIG.24

(a)

(c)

(b)

FIG.25

*FIG.26*

*FIG.27*

NORMALIZED POLARIZATION DEGREE OF LIGHT EXTRACTED FROM TRANSPARENT ENCAPSULATING MEMBER

ANGLE FORMED BETWEEN SYMMETRY PLANE OF TRANSPARENT ENCAPSULATING MEMBER AND POLARIZATION DIRECTION OF NITRIDE SEMICONDUCTOR LIGHT-EMITTING ELEMENT [deg.]

## INTERNATIONAL SEARCH REPORT

| | International application No. |
|---|---|
| | PCT/JP2011/004425 |

**A.   CLASSIFICATION OF SUBJECT MATTER**
*H01L33/54*(2010.01)i

According to International Patent Classification (IPC) or to both national classification and IPC

**B.   FIELDS SEARCHED**

Minimum documentation searched (classification system followed by classification symbols)
H01L33/00-33/64

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| A | JP 2009-123803 A  (Sanyo Electric Co., Ltd.), 04 June 2009 (04.06.2009), entire text; all drawings (Family: none) | 1-34 |
| A | JP 2008-109098 A  (Sanyo Electric Co., Ltd.), 08 May 2008 (08.05.2008), entire text; all drawings & US 2008/0258156 A1 | 1-34 |
| A | JP 2010-056282 A  (Tohoku University), 11 March 2010 (11.03.2010), entire text; all drawings (Family: none) | 1-34 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 31 October, 2011 (31.10.11) | 08 November, 2011 (08.11.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
|---|
| PCT/JP2011/004425 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-073962 A (Panasonic Electric Works Co., Ltd.), 02 April 2010 (02.04.2010), entire text; all drawings (Family: none) | 1-34 |
| A | JP 2006-134992 A (Hitachi Displays, Ltd.), 25 May 2006 (25.05.2006), entire text; all drawings & US 2006/0092634 A1 & KR 10-2006-0052423 A & CN 1783485 A & TW 289366 B | 1-34 |
| A | JP 10-223021 A (Nichia Chemical Industries, Ltd.), 21 August 1998 (21.08.1998), entire text; all drawings (Family: none) | 1-34 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008109066 A
- JP 2008109098 A